# EUROPEAN PATENT SPECIFICATION

(11) **EP 0 822 448 B1**
(45) Date of publication and mention of the grant of the patent: **02.11.2000**
(21) Application number: 97111219.8
(22) Date of filing: 03.07.1997
(51) Int. Cl.: G03F 7/033, G03F 7/027

(54) **Flexible, flame-retardant, photoimageable composition for coating printed circuits**
Flexible, flammhemmende fotopolymerisierbare Zusammensetzung zur Beschichtung von Leiterplatten
Composition photopolymérisable, flexible et ignifuge, pour le revêtement de circuits imprimés

(30) Priority: 02.08.1996 US 691616
(43) Date of publication of application: 04.02.1998
(73) Proprietor: E.I. DU PONT DE NEMOURS AND COMPANY, Wilmington Delaware 19898 (US)
(72) Inventor: Dueber, Thomas Eugene, Wilmington, Delaware 19803 (US); Schadt, III, Frank Leonard, Wilmington, Delaware 19806 (US); Lee, Yueh-Ling, Columbus, Ohio 43220 (US)
(74) Representative: Towler, Philip Dean

(56) References cited:
- EP-A- 0 361 409
- EP-A- 0 488 339
- EP-A- 0 676 669
- WO-A-93/17368
- FR-A- 2 369 590

## Description

### BACKGROUND OF THE INVENTION

The present invention relates to a flexible, flame-retardant, aqueous processable, photoimageable resin composition and a photoimageable element that is flexible after processing and cure. More specifically, the invention relates to a flexible, flame-retardant, aqueous processable, photoimageable resin composition for forming a permanent, protective coating film having excellent properties which can be used for the protection of printed circuitry during its lifetime, and to a multilayer photoimageable element comprising a layer of said composition in combination with a low tack photoimageable resin sublayer and a temporary support film.

The flame-retardant photoimageable resin composition has excellent aqueous developability and yields a cured coating film having good flexibility, adhesion, solvent resistance, surface hardness, thermal resistance, electrical insulating properties and Underwriters Laboratory 94VTM-0 flame retardency on flexible polyimide laminates that contain active flame retardants in the adhesive layer, e.g. Pyralux® FR and Teclam® (commercially available from E. I. du Pont de Nemours and Company) and on adhesiveless polyimide laminates. The photoimageable resin composition is suitable for use as a solder resist in the fabrication of printed circuit boards.

### DESCRIPTION OF THE PRIOR ART

Photopolymerizable resist materials are known, for example, from U.S. Patent Nos. 3,469,982 and 3,547,730, which describe a film resist with a sandwich structure in the form of a photopolymerizable layer between a cover sheet and a temporary support. Such a primary film resist can, for instance, be laminated on a copper base, exposed imagewise and developed with organic solvents or aqueous solutions, whereby a defined resist layer is formed. Typically the copper base for a printed circuit board is rigid, with limited flexibility of just a few degrees, such as the conventional copper-clad fiberglass epoxy laminates. More recently, printed circuits are being prepared on highly flexible film substrates to form electronic packages which may be folded and refolded one or more times to fit a specified configuration or a dynamic mechanical operation.

The defined resist layer thus produced can now be selectively etched, electroplated or treated with solder on the substrate. Particularly high demands are placed on photoresist films if they are used as permanent coatings that function as solder resists or masks. In this case, the developed, photopolymerized layer must withstand temperatures up to 300°C without degradation, loss of adhesion or accumulation of residues contained in or on the molten solder. With the advanced technology of today's printed circuit boards, it is important to have the capability to photoimage a solder mask. According to the current state of the art, such solder masks can be applied by spraying, coating or calendaring liquid compositions on a substrate or also by laminating a dry film on a substrate.

Due to the general adverse environmental impact of organic solvents, aqueous developable photopolymer systems with fast development are now preferred. The use of photopolymer resists with acid functions, primarily carboxyl functions, is known to impart aqueous processability. However, these groups are disadvantageous in many subsequent steps or events. In the case of primary photoresists, delamination of the resist is observed in alkali etching or gold plating and, in the case of solder masks, inadequate environmental resistance can occur. Modification of the carboxyl groups with melamine formaldehyde compounds to overcome the named disadvantages is known (EP 01 15 354 and U.S. Patent No. 4,247,621).

The utilization of polymers containing carboxylic acid groups that are subsequently converted to less reactive and less moisture sensitive species is also known. U.S. Patent 4,987,054 discloses a photopolymerizable formulation yielding improved properties containing an acid copolymeric binder wherein a copolymer structural unit is the half acid/amide of a dicarboxylic acid. The disclosed formulations are used with conventional rigid printed circuit boards, processed with wholly aqueous alkaline solutions and are storage stable. European Patent Application EP 430,175 discloses a photopolymeric system similar to U.S. 4,987,054.

International Patent Application WO 93/17368 and U.S.5,536,620 disclose an aqueous processable, photoimageable, permanent coating composition for printed circuits comprising (a) a cobinder consisting of a low molecular weight amic acid copolymer and a high molecular weight carboxylic acid-containing copolymer, (b) an acrylated urethane monomer component, (c) a photoinitiator system, and (d) a melamine formaldehyde thermal crosslinking agent.

U.S. 5,288,589 discloses a two layer photoimageable, aqueous processable photoresist containing an amphoteric binder in the layer laminated directly to a printed circuit board thereby providing a permanent coating with improved adhesion throughout the lamination process while maintaining other desirable properties such as storage stability and circuit encapsulation.

(EP 676 669 discloses an aqueous processable, permanent, photopolymerizable composition for use as a pliable protective coating for flexible circuitry comprising as essential ingredients (a) a cobinder system, (b) an acrylated urethane monomeric component, (c) a photoinitiator or a photoinitiator system and (d) a specific blocked polyisocyanate cross-linking agent.

FR 2,369,590 discloses a radiation sensitive element comprising a support carrying a photopolymerisable composition layer comprising at least one addition polymerisable ethylenically unsaturated compound having a boiling point of at least 100°C at ambient pressure, an organic addition polymerisation initiator activated by actinic radiation in the ultraviolet to visible region of the spectrum, to generate free radicals and at least 20% by weight of a macromolecular organic polymer binder comprising at least 5% by weight acrylonitrile, characterised in that the composition contains at least 5% by weight halogen in relation to the total composition, covalently bonded to at least one of the constituents of the composition.

EP 361 409 discloses a flame-retardant liquid photosensitive resin composition consisting essentially of (a) a (meth)acrylate obtained by the reaction of a compound having two or more epoxy groups in the molecule with (meth)acrylic acid and a dibasic acid or its anhydride, the (meth)acrylate having an average acid value of 4 to 150 and a number average molecular weight of 300 to 5000, (b) a monomer having at least one (meth)acryloyloxy group and containing not less than 20% by weight bromine, (c) a monomer having two or more (meth)acryloyloxy groups in the molecule, (d) a monomer having one (meth)acryloyloxy group in the molecule, (e) at least one inorganic filler and (f) at least one photopolymerisation catalyst selected from the group consisting of photo-initiators and photosensitizers, wherein the content of bromine in the total composition is in the range of 0.5 to 28% by weight.

However, none of the above-mentioned prior art photoimageable compositions have a sufficient degree of flame retardency.

As the electronic industry is driven towards faster, more reliable and compact devices, there is an increasing need in the printed circuit field for a more flexible, permanent photoimageable coating that can withstand typical manufacturing process conditions, such as molten solder, and which additionally meets established government flammability standards.

### SUMMARY OF THE INVENTION

The present invention relates to a flexible, flame-retardant, photoimageable resin composition for forming a

permanent, protective coating on a flexible printed circuit board comprising:
(a) a brominated carboxylic copolymer binder comprising ring-brominated aromatic monomer units, alkyl acrylate, alkyl methacrylate or non-brominated aromatic monomer units, wherein alkyl contains from 1 to 20 carbon atoms, and ethylenically unsaturated carboxylic acid monomer units and having a weight average molecular weight (M_{w}) of from 40,000 to 500,000 and containing from 3 to 50% bromine by weight;
(b) a non-brominated carboxylic copolymer binder having a weight average molecular weight (M_{w}) of from 3,000 to 15,000 comprising from 2 to 50% by weight of at least one carboxylic acid containing monomer unit and from 50 to 98% by weight of at least one monomer unit of the formula 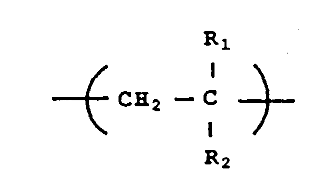 wherein R₁ is H, C₁₋₄ alkyl or aryl; R₂ is H, CH₃, aryl, -COOR₃, -CONR₄R₅ or -CN; and R₃, R₄ and R₅ are H, C₁₋₄ alkyl, aryl or C₁₋₄ alkyl or aryl substituted with one or more hydroxy, ester, keto, ether or thioether groups;
(c) an acrylated urethane monomeric component containing from 0 to 20% bromine by weight;
(d) optionally a brominated acrylated monomer containing from 10 to 80% bromine by weight with the proviso that (d) is not a urethane monomeric component;
(e) optionally a non-reactive or reactive brominated additive containing from 10 to 85% bromine by weight with the proviso that (e) is not an acrylated monomeric component or a blocked polyisocyanate crosslinking agent;
(f) a photoinitiator or a photoinitiator system; and
(g) a blocked polyisocyanate crosslinking agent containing from 0 to 30% bromine by weight,
wherein the total content of bromine in the composition ranges from 5 to 50% by weight.

In another aspect, the present invention relates to a flexible, flame-retardant, multilayer, photoimageable permanent coating element capable of adhering to a printed circuit board and withstanding molten solder after cure, comprising:
(1) a temporary support film;
(2) a first layer of a photoimageable permanent coating composition comprising:
   (a') an amphoteric binder;
   (b') a carboxyl group containing copolymer binder of the formula 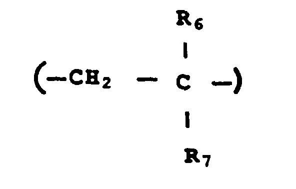 wherein R₆ is H or C₁₋₄ alkyl; R₇ is phenyl or -CO₂R₈; and R₈ is H or C₁₋₄ alkyl which can be substituted with one or more hydroxy groups;
   (c') a monomer component containing at least two ethylenically unsaturated groups; and
   (d') a photoinitiator or photoinitiator system;
(3) a second layer of a photoimageable permanent coating composition comprising:
   (a) a brominated carboxylic copolymer binder comprising ring-brominated aromatic monomer units, alkyl acrylate, alkyl methacrylate or non-brominated aromatic monomer units, wherein alkyl contains from 1 to 20 carbon atoms, and ethylenically unsaturated carboxylic acid monomer units and having a weight average molecular weight (M_{w}) of from 40,000 to 500,000 and containing from 3 to 50% bromine by weight;
   (b) a non-brominated carboxylic copolymer binder having a weight average molecular weight (Mw) of from 3,000 to 15,000 comprising from 2 to 50% by weight of at least one carboxylic acid containing monomer unit and from 50 to 98% by weight of at least one monomer unit of the formula 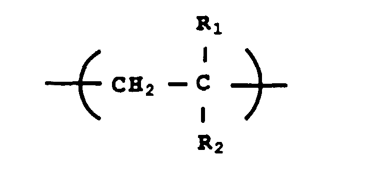 wherein R₁ is H, C₁₋₄ alkyl or aryl; R₂ is H, CH₃, aryl, -COOR₃, -CONR₄R₅ or -CN; and R₃, R₄ and R₅ are H, C₁₋₄ alkyl, aryl or C₁₋₄ alkyl or aryl substituted with one or more hydroxy, ester, keto, ether or thioether groups;
   (c) an acrylated urethane monomeric component containing from 0 to 20% bromine by weight;
   (d) a brominated acrylated monomer containing from 10 to 80% bromine by weight with the proviso that (d) is not a urethane monomeric component;
   (e) a non-reactive or reactive brominated additive containing from 10 to 85% bromine by weight with the proviso that (e) is not an acrylated monomeric component or a blocked polyisocyanate crosslinking agent;
   (f) a photoinitiator or a photoinitiator system; and
   (g) a blocked polyisocyanate crosslinking agent containing from 0 to 30% bromine by weight,
wherein the total content of bromine in the second layer composition ranges from 5 to 50% by weight.

### DETAILED DESCRIPTION OF THE INVENTION

The flame-retardant, photoimageable resin composition that constitutes one aspect of the present invention is composed of essential components (a) to (g) listed above which are further described hereinbelow.

### (a) Brominated Carboxylic Copolymer Binder

The flame-retardant, photoimageable resin composition contains from 10 to 60% by weight, preferably from 25 to 45% by weight, of a brominated carboxylic copolymer binder (a) which is the polymerized reaction product of aromatic monomer units that are substituted on the aromatic ring with bromine and, preferably, an ethylenically unsaturated group, alkyl acrylate, alkyl methacrylate or non-brominated aromatic monomer units, and ethylenically unsaturated carboxylic acid monomer units. Proper selection of the respective monomers enables production of flame-retardant resin compositions useful in printed circuit applications. Representative of ring-brominated aromatic monomers are styrene, methylstyrene, alpha-methylstyrene, alpha-methyl methylstyrene, ethylstyrene or alpha-methyl ethylstyrene with bromine substitution (mono, di, tri and tetra) in the phenyl nucleus. Mixtures or mixed isomers of the above monomers may also be used. The preferred ring-brominated aromatic monomer is a brominated styrene, with dibromostyrene being most preferred.

The ring brominated aromatic monomer units are preferably present in an amount of from 5 to 55% by weight, preferably from 15 to 40% by weight, based on the weight of the copolymer, to provide from 3 to 50% bromine by weight, preferably from 5 to 30% bromine by weight, based on the weight of the copolymer. The brominated carboxylic acid copolymer component (a) provides the requisite flame-retardant properties and improved hardness and chemical resistance to the photoimageable resin composition.

Practical examples of the alkyl acrylate or alkyl methacrylate monomer unit are methyl acrylate, ethyl acrylate, n-propyl acrylate, isopropyl acrylate, n-butyl acrylate, isobutyl acrylate, n-amyl acrylate, n-hexyl acrylate, isohexyl acrylate, 2-ethylhexyl acrylate, n-heptyl acrylate, isoheptyl acrylate, 1-methylheptyl acrylate, n-octyl acrylate, 6-methylheptyl acrylate, n-nonyl acrylate, 3,5,5-trimethylacrylate, n-decyl acrylate, lauryl acrylate and the corresponding alkyl methacrylates and other primary, secondary and tertiary higher alkyl acrylates and methacrylates where the alkyl group can contain from 1 to 20, preferably from 2 to 10, carbon atoms. Practical examples of non-brominated aromatic monomers are styrene, methyl styrene, alpha-methylstyrene, alpha-methyl methylstyrene, ethylstyrene, alpha-methyl ethyl styrene, benzyl acrylate or benzyl methacrylate. The preferred monomers are ethyl acrylate, n-propyl acrylate, n-butyl acrylate, methyl methacrylate, and styrene. The alkyl (meth) acrylate monomer or non-brominated aromatic monomer is present in an amount of from 20 to 92% by weight, based on the weight of the copolymer, preferably from 40 to 75% by weight.

Practical examples of the ethylenically unsaturated monomer unit include acrylic acid, methacrylic acid, itaconic acid, maleic acid and fumaric acid. The preferred acids are acrylic and methacrylic acids. The unsaturated carboxylic acid monomer is present in an amount of from 3 to 25% by weight, preferably from 7 to 20% by weight, based on the weight of the copolymer.

A preferred brominated carboxylic copolymer is a copolymer of 25 weight % dibromostyrene, 59 weight % ethyl acrylate and 16 weight % acrylic acid having a weight average molecular weight (M_{w}) ranging from 40,000 to 500,000.

### (b) Non-brominated Carboxylic Copolymer Binder

The non-brominated carboxylic copolymer binder component (b) is present in an amount of from 2 to 15% by weight, preferably from 3 to 10% by weight, based on the total weight of the photoimageable composition and comprises from 2 to 50% by weight of at least one carboxylic acid containing monomer unit and from 50 to 98% by weight of at least one monomer unit of the formula 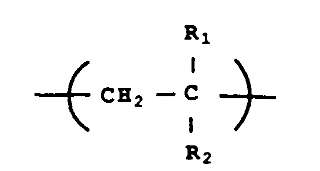 wherein R₁ is H, C₁₋₄ alkyl or aryl; R₂ is H, CH₃, aryl, -COOR₃, -CONR₄R₅ or -CN; and R₃, R₄ and R₅ independently are H, C₁₋₄ alkyl, aryl or C₁₋₄ alkyl or aryl substituted with one or more hydroxy, ester, keto, ether or thioether groups and having a weight average molecular weight (M_{w}) of from 3,000 to 15,000.

The carboxylic acid-containing monomer unit of the copolymer binder component can be formed from any ethylenically unsaturated carboxylic acid, or carboxylic acid precursor comonomer that subsequently can be reacted to form the acid, and which will polymerize to form the desired low molecular weight copolymer. Examples of suitable ethylenically unsaturated carboxylic acid or carboxylic acid precursor comonomers include acrylic and methacylic acids, maleic acid; maleic acid half ester or anhydride; itaconic acid; itaconic acid half ester or anhydride; citraconic acid; citraconic acid half ester or anhydride; and substituted analogues thereof.

Particularly preferred ethylenically unsaturated carboxylic acids are acrylic acid and methacrylic acid. The proportion of carboxylic acid-containing monomer unit in the copolymer binder ranges from 2 to 50% by weight, and preferably from 5 to 25% by weight.

The weight average molecular weight (M_{w}) of the carboxylic acid-containing copolymer binder is in the range of from 3,000 to 15,000, as measured by Gel Permeation Chromatography (GPC), preferably from 4,000 to 10,000.

Suitable comonomers which can be used in the copolymer binder include styrene, substituted styrenes, and unsaturated carboxylic acid derivatives, such as, for example, esters and amides of acrylic and methacrylic acids. Methyl methacrylate, ethyl methacrylate, butyl methacrylate, methacrylamide, methyl acrylate, ethyl acrylate, butyl acrylate, acrylamide, hydroxyethyl acrylate, hydroxyethyl methacrylate and styrene are preferred.

When the permanent coating is photoprinted, development of the composition requires that the carboxylic acid-containing copolymer binder component (b) contains sufficient acidic or other groups to render the composition processable in aqueous alkaline developer. The coating layer formed from the composition is removed in portions which are not exposed to radiation but is substantially unaffected in exposed portions during development by aqueous alkaline liquids such as wholly aqueous solutions containing 1% sodium or potassium carbonate by weight for a time period of five minutes at a temperature of 40°C.

The low molecular weight carboxylic acid-containing binder component (b) helps achieve end-use properties, such as encapsulation of circuit patterns without air entrapment, fast development in aqueous carbonate developer, flexibility, adhesion, resistance to environmental conditions and resistance to alkali etching or plating solutions.

A particularly preferred carboxylic acid-containing binder component (b) comprises a copolymer of 92 weight % ethyl acrylate and 8 weight % acrylic acid having a weight average molecular weight (M_{w}) of about 5,000 to 8,000 and which is present in an amount of up to 5 weight % of the composition.

### (c) Acrylated Urethane Monomeric Component

An acrylated urethane monomeric component (c) is an essential ingredient of the photoimageable composition, since it imparts increased flexibility to the cured layer and reduced brittleness, when used in the correct proportion with the other essential ingredients of the composition. It is known that many factors can influence the properties (e.g. glass transition temperature) and thus performance of urethane structures in a particular application. These factors include diisocyanate type, diol molecular weight, codiols (i.e. short chain diols), ratio of diol to codiol, as well as the amount of branching and molecular weight of the resultant polyurethane. Properties after acrylation will vary correspondingly. It is important to choose the proper acrylated urethane and amount of such relative to the other essential ingredients in order to obtain a proper balance of flexibility, toughness and chemical resistance in the permanent coating. The acrylated urethane is present in an amount of from 5 to 30% by weight, preferably from 8 to 20% by weight, and contains at least one acrylate or methacrylate group.

Preferred types of acrylated urethanes have the general formula: 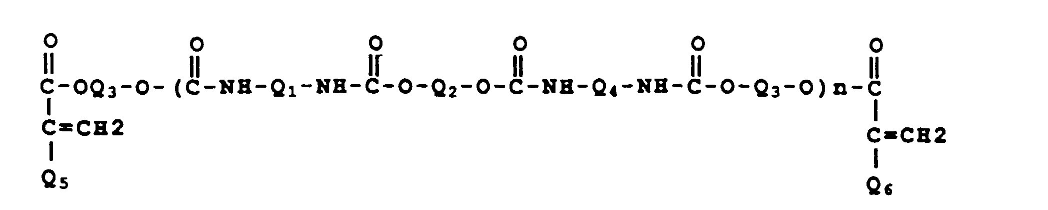 wherein Q1 and Q4 are aromatic groups which may be unsubstituted or substituted by lower alkyl groups and which can contain a lower alkylene group as a connecting member; Q2 and Q3 are independently polyoxyalkylene groups containing 1 to 10 carbon atoms; Q5 and Q6 are independently alkyl of 1 to 3 carbon atoms or H, and n is at least one.

Particularly preferred is a urethane diacrylate which is the reaction product of 2,6-toluene diisocyanate with a polyol with the end isocyanate groups end-capped with hydroxyethyl acrylate.

The (meth)acrylated urethane may also include di(meth)acrylates and tri(meth)acrylates which are carboxylated to provide acid numbers ranging from 1 to 50 or more and molecular weights ranging from 500 to 5000. Carboxylated urethane di(meth)acrylates and tri(meth)acrylates are particularly advantageous since they provide cleaner development in aqueous basic developer.

In order to increase flame-retardency of the photoimageable composition, acrylated urethanes containing one or more bromine atoms may be used to provide a bromine content of up to 20% bromine by weight. Examples of brominated urethane (meth)acrylates include reaction products of dibromoneopentyl glycol or the bis(2-hydroxyethylether) of tetrabromobisphenol-A with hexamethylene diisocyanate and end-capped with hydroxyethyl acrylate, or the reaction product of dibromoneopentyl glycol and polyols with aliphatic or aromatic diisocyanates and end-capped with hydroxyethyl acrylate.

### (d) Brominated Acrylated Monomer

The photoimageable composition contains from 0 to 40% by weight, preferably from 10 to 30% by weight, based on the weight of the composition, of a brominated acrylated monomer (d) containing at least one (meth)acryloyloxy group and having a bromine content of from 10 to 80% bromine by weight.

Use of the bromine containing acrylated monomer containing not less than 10% by weight of bromine makes it possible to produce a flame-retardant photoimageable resin composition having excellent alkaline developability, yielding a cured coating film having good adhesion, solvent resistance, thermal resistance, low residue after development and exhibiting excellent flame retardancy.

Specific examples of the bromine containing acrylated monomer (d) include bis-(3-methacryloyloxy-2-hydroxypropyl) ether of tetrabromobisphenol-A, bis-(3-acryloyloxy-2-hydroxypropyl)ether of tetrabromobisphenol-A, bis-(2-methacryloyloxyethyl)ether methacryloyloxyethyl)ether of tetrabromobisphenol-A, of tetrabromobisphenol-A, 2-tribromophenoxyethyl methacrylate, 2-(2-tribromophenoxyethoxy)ethyl acrylate, tribromophenyl acrylate, pentabromobenzyl acrylate, pentabromobenzyl methacrylate, tribromoneopentyl acrylate, and the reaction products of diepoxy oligomers of tetrabromobisphenol-A and epichlorohydrin with acrylic or methacrylic acid followed by reaction of one or more hydroxyls per molecule with anhydrides such as succinic anhydride.

### (e) Brominated Additive

The flame-retardant photoimageable resin composition contains from 0 to 40% by weight, preferably from 0 to 20% by weight, of a brominated additive(e) containing from 10 to 85% bromine by weight for imparting improved flame retardancy. The brominated additive (e) may be substantially non-reactive or, preferably, may be reactive with one or more of the other components of the photoimageable composition. Such reactivity can provide a more fully cured matrix thereby enhancing end-use properties and preventing migration of additives within the cured matrix under accelerated or environmental conditioning.

Examples of reactive brominated additives include 3,4,5,6-tetrabromo-1,2-benzene dicarboxylic acid mixed esters with diethylene glycol and propylene glycol or with diethylene glycol and ethylene glycol, diester/ether diol of tetrabromophthalic anhydride, bis-(2-hydroxyethyl)ether of tetrabromobisphenol-A, 2,2-bis-(bromomethyl)-3-bromo-1-propanol, 2,2-bis-(bromomethyl)-1,3-propanediol, di(tribromophenolate) of tetrabromo-bisphenol-A diglycidyl ether and succinic esters thereof, tetrabromobisphenol-A, brominated poly(p-vinylphenol), and poly(dibromophenylene oxide).

Examples of substantially non-reactive brominated additives include di-2-ethylhexyl tetrabromophthalate and tris (dibromophenyl)phosphate.

From 0 to 40% by weight of a flame-retardant, brominated filler compound may also be added to the photoimageable composition to further enhance flame-retardant properties. Examples of flame-retardant fillers include ethylene bis(tetrabromophthalimide), decabromodiphenyl oxide, bis(tribromophenoxy)ethane, poly(pentabromobenzyl acrylate).

### (f) Photoinitiator System

The photoinitiator system (f) contains one or more initiator compounds that directly furnish free-radicals when activated by actinic radiation. The system also may contain a sensitizer that is activated by the actinic radiation, causing the initiator compound to furnish the free-radicals. The sensitizer may extend spectral response into the near ultraviolet, visible, and near infrared spectral regions.

The photoinitiator system comprises from 0.01 to 10% by weight, preferably from 0.01 to 5% by weight, of the photoimageable composition.

Numerous conventional photoinitiator systems are known to those skilled in the art and may be used herein provided they are compatible with the other ingredients of the coating composition. A-large number of free-radical generating compounds, including redox systems such as Rose Bengal/2-dibutylaminothanol, may be selected to advantage. A useful discussion of dye sensitized photopolymerization can be found in "Dye Sensitized Photo-polymerization" by D. F. Eaton in Adv. in Photochemistry, Vol. 13, D. H. Volman, G. S. Hammond, and K. Gollinick, eds., Wiley-Interscience, New York, 1986, pp. 427-487.

Sensitizers useful with photoinitiators include methylene blue and those disclosed in U.S. Patents 3,554,753; 3,563,750; 3,563,751; 3,647,467; 3,652,275; 4,162,162; 4,268,667; 4,351,893; 4,454,218; 4,535,052; and 4,565,769. A preferred group of sensitizers include the bis(p-dialkylaminobenzylidene) ketones disclosed in Baum et al, U.S. Patent 3,652,275, and the arylidene aryl ketones disclosed in Dueber, U.S. Patent 4,162,162.

Preferred photoinitiator systems are 2,4,5-triphenylimidazolyl dimers in combination with chain transfer agents, or hydrogen donors, such as are disclosed in U.S. Patents 3,479,185; 3,784,557; 4,311,783; and 4,622,286. Preferred hexaaryl-biimidazoles (HABI) are 2-o-chlorosubstituted hexaphenyl-biimidazoles in which the other positions on the phenyl radicals are unsubstituted or substituted with chloro, methyl or methoxy. The most preferred initiator is o-Cl-HABI, i.e., 1,1'-biimidazole, 2,2'-bis(o-chlorophenyl)-4,4',5,5'-tetraphenyl-imidazole dimer.

Hydrogen donor compounds that function as chain transfer agents in the photopolymer compositions include: 2-mercaptobenzoxazole, 2-mercaptobenzo-thiazole, 4-methyl-4H- 1,2,4-triazole-3-thiol; as well as various types of compounds, e.g., (a) ethers, (b) esters, (c) alcohols, (d) compounds containing allylic or benzylic hydrogen, (e) acetals, (f) aldehydes, and (g) amides disclosed in column 12, lines 18 to 58 of MacLachlan U.S. Patent 3,390,996. Suitable hydrogen donor compounds for use in systems containing both biimidazole type initiator and N-vinyl carbazole are 5-chloro-2-mercaptobenzothiazole; 2- mercaptobenzothiazole; 1H-1,2,4-triazole-3-thiol; 6-ethoxy-2- mercaptobenzo-thiazole; 4-methyl-4H-1,2,4-triazole-3-thiol; 1- dodecanethiol; and mixtures thereof.

A particularly preferred class of photoinitiators and photosensitizers are benzophenone, Michler's ketone, ethyl Michler's ketone, p-dialkylaminobenzaldehydes, p-dialkylaminobenzoate alkyl esters, polynuclear quinones, thioxanthones, hexaarylbiimidazoles, cyclohexadienones, benzoin, benzoin dialkyl ethers, or combinations thereof where alkyl contains 1 to 4 carbon atoms.

### (g) Blocked Polyisocyanate Crosslinking Agent

The photoimageable compositions are generally applied to a substrate by lamination or from solution. In these processes, the composition is heated, for example, during the lamination operation or during evaporation of the solvent after application from solution. Partial crosslinking can take place in the unexposed areas even before photostructuring, which results in impairment of image quality. Thus, a desirable property of the photoimageable composition is that it undergoes as little crosslinking as possible due to this heat treatment. On the other hand, it is also desirable that the composition be cured rapidly and at moderate temperatures after application and imagewise exposure in order to obtain high throughput and simultaneous savings of energy costs.

According to the present invention, a thermally activated crosslinking agent is used which crosslinks with the reactive functional groups, such as hydroxyl, carboxyl, amide and amine groups which are present in the copolymer binder components and other ingredients in the photoimageable coating composition. The presence of the proper crosslink imparts the capability to withstand molten solder temperature and improves chemical resistance or other mechanical or chemical properties required in the end-use product.

The preferred crosslinking agent is a blocked polyisocyanate which has a cleavage temperature of at least 100°C, or a mixture of polyisocyanates of this type. In the context of this description, this is to be understood as meaning a blocked polyisocyanate in which at least half of the blocked isocyanate groups are deblocked at a temperature of at least 100°C and are thereby available for reaction with the isocyanate-reactive functional groups of the other components of the photoimageable composition.

The polyisocyanate on which the blocked component is based may be any aliphatic, cycloaliphatic, aromatic or arylaliphatic compounds having at least two, preferably two to four, isocyanate groups and which may have further substituents which are inert to isocyanate groups, such as alkyl or alkoxy groups.

These include, for example, the following compounds: 2,4-diisocyanatotoluene, and technical grade mixtures thereof with 2,6-diisocyanatotoluene, 1,5-diisocyanatonaphthalene, 1,4-diisocyanatonaphthalene, 4,4'-diisocyanatodiphenylmethane and technical grade mixtures of various diisocyanatodiphenylmethanes (for example the 4,4'- and 2,4'-isomers), diisocyanato-m-xylylene, N,N'-di(4-methyl-3-isocyanatophenyl)urea, 1,6-diisocyanatohexane, 1,12-diisocyanatododecane, 3,3,5-trimethyl-1-isocyanatomethylcyclohexane (isophorone diisocyanate), trimethyl-1,6-diisocyanatohexane, 1-methyl-2,4-diisocyanatocyclohexane, trisisocyanato-triphenyl-methane and 4,4'-diisocyanatodicyclo-hexylmethane.

The polyisocyanates may be blocked by various radicals. Examples of suitable blocking components are beta-dicarbonyl compounds, such as malonates, acetoacetates or 2,4-pentanedione, or hydroxamates, triazoles, imidazoles, tetrahydropyrimidines, lactams, oximes, ketoximes, low molecular weight alcohols, or phenols or thiophenols.

The blocked polyisocyanate may also be a urethanized, carbodiimidated, biuretized, or dimerized or trimerized polyisocyanate, a trimer containing an isocyanurate ring, a biscyclic urea compound, a polymeric isocyanate, a copolymer of two or more diisocyanates, or other forms of polyisocyanates which are inactive below 100°C, so long as their cleavage temperature is at least 100°C. Examples of these are urethanized 4,4'-diisocyanato-diphenylmethane, carbodiimidated 4,4'-diisocyanatodiphenylmethane, uretdione of 2,4-diisocyanatotoluene, the trimer of diisocyanatotoluene, N,N',N"-tri (6-isocyanatohexyl)-biuret, isophorone diisocyanate, trimeric hexane diisocyanates, trimeric dodecane diisocyanates, adipoyl bis(propylene urea), and azelaoyl bis(propylene urea).

Preferred blocked polyisocyanates have a cleavage temperature between 100°C to 200°C. Particularly preferred herein are methylethyl ketoxime blocked 1,6-diisocyanatohexane trimers, methylethyl ketoxime blocked isophorone diisocyanate, and the reaction products of 1,6-diisocyanatohexane or trimer thereof with bis(2-hydroxyethylether) of tetrabromobisphenol-A blocked with methyl ethyl ketoxime and are present in an amount of from 2 to 20% by weight, preferably from 5 to 15% by weight, based on the weight of the photoimageable composition and containing up to 30% bromine by weight to improve flame-retardancy of the composition.

Compared with photoimageable compositions cured using melamine-formaldehyde crosslinking agents, the photoimageable coating compositions of the invention are distinguished, surprisingly, by higher elongation and better chemical resistance at lower cure temperature. In addition, the cured coatings maintain their flexibility after cure. Other crosslinking agents, such as melamine-formaldehyde crosslinking agents, can be used but may require higher cure temperatures to obtain the same flex stability after cure, and sometimes lose some of this flexibility while aging under cool and/or dry conditions. To maintain stability of the laminate material, the cure temperature should be as low as possible above 100°C, since flexible circuits undergo more distortion at higher cure temperatures.

### Fillers

The aqueous processable, photoimageable coating compositions of this invention may optionally contain a preformed macromolecular elastomeric component as an organic filler. This elastomeric component typically is present as a separate micro-phase in the aqueous processable coating composition, and as such is believed to be functioning as an elastomeric filler for the composition. Typically, such organic components contain substantially no acidic groups and consequently are insoluble in aqueous, alkaline developer solutions. However, dispersibility in the permanent coating composition and aqueous, alkaline developer solutions may be improved by incorporating sufficient carboxylic acid groups into the organic filler component if improvement in such development is required.

Although many elastomers may be used in the photoimageable composition, poly(methyl methacrylate-co-butadiene-co-styrene) is preferred. Other organic fillers which may be used include synthetic flexible polymers and rubbers, e.g., butadiene-co-acrylonitrile, acrylonitrile-co-butadiene-co-styrene, methacrylate-co- acrylonitrile-co-butadiene-co-styrene copolymers, and styrene-co-butadiene-co-styrene, styrene-co-isoprene-co-styrene block copolymers; saturated polyurethanes and poly(methylmethacrylate-co-butylacrylate). Further examples of organic filler components include conventional elastomers as defined on page 232 of "Hackh's Chemical Dictionary" Fourth Edition, Edited by J. Grant, McGraw-Hill Book Company, 1972.

The photoimageable compositions may also contain other organic fillers or inorganic particulates to modify the mechanical or chemical properties required during processing or end use. Suitable fillers include organic or inorganic reinforcing agents which are essentially transparent as disclosed in U.S. Patent 2,760,863, e.g., organophilic silica bentonite, silica, and powdered glass having a particle size less than 0.4 micrometer; inorganic thixotropic materials as disclosed in U.S. Patent 3,525,615 such as boehmite alumina, clay mixtures of highly thixotropic silicate oxide such as bentonite and finely divided thixotropic gel containing 99.5% silica with 0.5% mixed metallic oxide; microcrystalline thickeners as disclosed in U.S. Patent 3,754,920 such as microcrystalline cellulose and microcrystalline silicas, clays, alumina, bentonite, kalonites, attapultites, and montmorillonites; finely divided powders having a particle size of 0.5 to 10 micrometers as disclosed in U.S. Patent 3,891,441 such as silicon oxide, zinc oxide, and other commercially available pigments; and the binder-associated, transparent, inorganic particles as disclosed in European Patent Application 87113013.4 such as magnesium silicate (talc), aluminum silicate (clay), calcium carbonate and alumina. Typically, the filler is transparent to actinic radiation to preclude adverse effects during imaging exposure. Depending on its function in the photoimageable composition, the filler may be colloidal or have an average particle size of 0.5 micrometers or more in diameter.

### Adhesion Promotor

The photoimageable composition may also contain a heterocyclic or mercaptan compound to improve adhesion of the coating to the metal circuit pattern during processing or in the end-use product. Suitable adhesion promotors include heterocyclics such as those disclosed in Hurley et al, U.S. Patent 3,622,334, Jones, U.S. Patent 3,645,772, and Weed, U.S. Patent 4,710,262. Preferred adhesion promoters include benzotriazole, 5-chloro-benzotriazole, 1-chloro-benzotriazole, 1-carboxy-benzotriazole, 1-hydroxy-benzotriazole, 2-mercapto benzoxazole, 1H-1,2,4-triazole-3-thiol, 5-amino-1,3,4-thiadiazole-2-thiol, and mercapto-benzimidazole.

### Other Components

Other compounds conventionally added to photopolymer compositions may also be present in the photoimageable composition to modify the physical properties of the film. Such components include: thermal stabilizers, colorants such as dyes and pigments, coating aids, wetting agents and release agents.

Thermal polymerization inhibitors that can be used in the permanent coating compositions are: Irganox® 1010, p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6-di-tert-butyl-p-cresol, phenothiazine, p-toluquinone and chloranil. Also useful as thermal polymerization inhibitors are the nitroso compounds disclosed in U.S. 4,168,982.

Various dyes and pigments may be added to increase the visibility of the resist image. Any colorant used, however, should preferably be transparent to the actinic radiation used.

The photopolymerizable compositions of this invention can also contain non-brominated flame retardants or synergists such as diethyl-N,N-bis(2-hydroxyethyl) aminomethyl phosphonate, gamma-dipropanolisobutylphosphine oxide, resorcinol bis(diphenylphosphate), poly(aryloxyphosphazenes) and tri(isopropylphenyl) phosphate.

In order to achieve adequate flame retardancy, an amount of antimony oxide can be added which is known to be a synergistic flame retardant when added to brominated compounds. Any of the antimony oxides can be used, preferably as a colloidal dispersion.

Photopolymerizable compositions of this invention can also contain a non-brominated, nongaseous ethylenically unsaturated compound having a boiling point above 100°C at normal atmospheric pressure and being capable of forming a high polymer by photoinitiated addition polymerization, such as mono or polyfunctional acrylates or methacrylates. Suitable monomers which can be used to optimize desired properties include the following: t-butyl acrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in U.S. Patent 3,380,831, 2,2-di(p-hydroxyphenyl)-propane diacrylate, pentaerythritol tetraacrylate, 2,2-di-(p-hydroxyphenyl)- propane dimethacrylate, triethylene glycol diacrylate, polyoxyethyl-2,2-di-(p-hydroxyphenyl)-propane dimethacrylate, bis(3-methacryloxy-2-hydroxypropyl)ether of bisphenol-A, bis(2-methacryloxyethyl)ether of bisphenol-A, bis(3-acryloxy-2-hydroxypropyl)ether of bisphenol-A, bis(2-acryloxyethyl)ether of bisphenol-A, bis(3-methacryloxy-2-hydroxypropyl)ether of 1,4-butanediol, bis(3-methacryloxy-2-hydroxypropyl)ether of diphenolic acid, triethylene glycol dimethacrylate, polyoxypropylene trimethylol propane triacrylate (462), ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4-diisopropenyl benzene, and 1,3,5-triisopropenyl benzene. A class of monomers are an alkylene or a polyalkylene glycol diacrylate prepared from an alkylene glycol of 2 to 15 carbons or a polyalkylene ether glycol of 1 to 10 ether linkages, and those disclosed in U.S. Patent 2,927,022, e.g., those having a plurality of addition polymerizable ethylenic linkages particularly when present as terminal linkages. Preferred are those wherein at least one and preferably most of such linkages are conjugated with a double bonded carbon, including carbon double bonded to carbon and to such heteroatoms as nitrogen, oxygen and sulfur. Also preferred are such materials wherein the ethylenically unsaturated groups, especially the vinylidene groups, are conjugated with ester or amide structures.

Based on essential components (a) to (g) described hereinabove, a preferred flame-retardant, photoimageable resin composition comprises (a) from 25 to 45% by weight of a copolymer of 25 weight % of dibromostyrene, 59 weight % of ethyl acrylate and 16 weight % of acrylic acid having a weight average molecular weight (M_{w}) of 40,000 to 500,000 and containing from 5 to 30% bromine by weight; (b) from 3 to 10% by weight of an acrylic copolymer of 92 weight % of ethyl acrylate and 8 weight % acrylic acid having a weight average molecular weight (M_{w}) of 5,000 to 8,000; (c) from 8 to 20% by weight of a urethane diacrylate derived from the reaction of 2,6-toluene diisocyanate and a polyol, end-capped with hydroxyethyl acrylate; (d) from 10 to 30% by weight of a brominated epoxy diacrylate derived from the reaction of tetrabromobisphenol-A diglycidyl ether with acrylic acid and containing from 10 to 80% bromine by weight; (e) from 0 to 20% by weight of a reactive mixed diester of 3,4,5,6-tetrabromo-1,2-benzene dicarboxylic acid with diethylene glycol and propylene glycol containing from 10 to 85% bromine by weight; (f) from 0.01 to 10% by weight of a photoinitiator system; and (g) from 5 to 15% by weight of a methyl ethyl ketoxime blocked 1,6-diisocyanatohexane trimer thermal cross-linking agent, wherein the total amount of bromine in the composition ranges from 5 to 50% by weight.

A further aspect of the present invention relates to a flame-retardant, aqueous processable, photoimageable, multilayer, permanent coating element that has sufficiently low tack to avoid premature adhesion when placed in contact with a printed circuit substrate, but yet develops good adhesion to the substrate upon application of heat and pressure during lamination. The coating element effectively encapsulates raised relief structures without air entrapment and can be rapidly developed in aqueous 1% sodium or potassium carbonate in less than 5 minutes at 40°C. The coating element also has acceptable end-use properties such as resistance to multiple 260°C solder exposures for 2 to 6 seconds, resistance to gold plating baths and other permanent coating properties as described in the Institute for Printed Circuits (IPC) Solder Mask 840B Specification.

The photoimageable coating element provides an overall balance of desirable properties including excellent flame-retardancy by using at least two different layers of photoimageable permanent coatings. The layer of photoimageable coating in direct contact with the printed circuit substrate, or first layer, contains at least 5% by weight of an amphoteric binder which provides a layer having sufficiently low tack to avoid premature adhesion to the printed circuit substrate but develops good adhesion to the circuit substrate upon application of heat and pressure during lamination. The photoimageable composition of the second layer is previously described hereinabove and provides the solder resistance and the flame-retardant properties mentioned above.

The first layer of photoimageable permanent coating may be adjacent to a support film or a cover film. Preferably, the first layer is applied by conventional means to the temporary support film from a solution and then dried. The second layer of photoimageable permanent coating may be applied as a solution or a preformed layer to the exposed surface of the first layer by conventional means to obtain high adhesion between these two layers. In an alternative embodiment, the second layer also may be applied as a solution to the temporary support film, and then the first layer may be applied as a solution or a preformed layer to the exposed surface of the second layer by conventional means to obtain high adhesion between the two layers. In these two embodiments, a temporary support film is preferably laminated to the exposed surface of the second layer, or a cover film is laminated to the exposed surface of the first layer, respectively, so that the first and second photoimageable permanent coating layers are sandwiched between and protected by the support film and the cover film. For the two cases, the first layer should release from its protective cover layer before the second layer releases from its protective support layer. Upon removal of the cover film, the first layer can be applied to the printed circuitry while the second layer still remains protected. The first layer which is in contact with the circuit substrate, usually copper and dielectric, has low adhesion to the circuit substrate under ambient conditions, but develops high adhesion upon application of heat and pressure such as during vacuum or roll lamination processing. The first layer has high adhesion to the second layer, so that after lamination under heat and pressure, the remaining protective support film can be removed from the second layer without delamination between the two layers or between the first layer and the circuit substrate.

The first and second layers are developable with about the same concentration of aqueous alkaline solution, such as 1% sodium or potassium carbonate in less than 5 minutes at 40°C, so that the entire thickness of the first and second layers can be washed away in a single development step to leave a resist image of both layers on the substrate surface.

The combined thickness of the photoimageable layers depends on the relief pattern on the surface of the circuit substrate. Generally, the total thickness will be no greater than 125 microns [µm] (5 mils). When the permanent coating composition is used in vacuum or roll lamination, the total thickness will generally be no greater than 76 microns [µm] (3 mils). Normally, the first layer will comprise from 0.01 to 30%, preferably from 0.05 to 10%, of the combined layer thickness.

### Temporary Support Film

Any of the support films generally known for use in photoresist films can be used. The temporary support film, which preferably has a high degree of dimensional stability to temperature changes, may be selected from a wide variety of polyamides, polyolefins, polyesters, vinyl polymers and cellulose esters, and may have a thickness ranging from 6 to 200 microns [µm]. A particularly preferred support film is polyethylene terephthalate having a thickness of about 25 microns [µm]. The temporary support film can be surface treated to improve release properties with substances such as silicones. At least one surface of the support film may have a matte surface obtained by incorporation of filler particles in, or embossing the surface of, the temporary support film.

### Cover Film

The photoimageable permanent coating layer may be protected by a removable cover film to prevent blocking when it is stored in roll form which is removed prior to lamination. The protective cover film may be selected from the same group of high polymer films described for the temporary support film, supra, and may have the same wide range of thicknesses. A cover film of 15-30 microns [µm] thick polyethylene or polypropylene, polyethylene terephthalate or silicone treated polyethylene terephthalate, are especially suitable. At least one surface of the cover film may have a matte surface obtained either by incorporation of filler particles in, or embossing the surface of, the cover film.

The first layer of the multilayer photoimageable permanent coating, preferably, contains (a') from 5 to 25% by weight of amphoteric binder, (b') from 30 to 80% by weight of carboxyl containing copolymer binder, (c') from 5 to 30% by weight of an ethylenically unsaturated monomer; and (d') from 0.5 to 10% by weight of a photoinitiator or photoinitiator system.

### (a') Amphoteric Binder

The first photoimageable permanent coating layer contains, as an essential component (a'), from 5 to 25% by weight of the layer composition of an amphoteric polymer binder.

The amphoteric polymers which are necessary components of the first layer of the photoimageable composition are copolymers derived from the copolymerization of (1) at least one basic comonomer which is an acrylic or methacrylic acrylamide or methacrylamide, an aminoalkyl acrylate or methacrylate or mixture of any of these; (2) at least one acidic comonomer containing one or more carboxyl groups and (3) at least one further comonomer which is acrylic or methacrylic in character.

The applicable N-substituted acrylamides or methacrylamides are substituted with alkyl radicals containing from 1-12 carbon atoms. Among the applicable acrylamides and methacrylamides are included N-ethyl acrylamide, N-tertiary-butyl acrylamide, N-n-octyl acrylamide, N-tertiary-octyl acrylamide, N-decyl acrylamide, N-dodecyl acrylamide, as well as the corresponding methacrylamides. Suitable aminoalkyl compounds are the (C₁₋₄) alkyl (C₂₋₄) aminoalkyl acrylates and methacrylates.

Suitable acidic comonomers for the amphoteric polymers are those having at least one available carboxylic acid group. These include acrylic acid, methacrylic acid, crotonic acid, itaconic acid, maleic acid, fumaric acid and the C₁-C₄ alkyl half esters of maleic and fumaric acids, such as methyl hydrogen maleate and butyl hydrogen fumarate as well as any other acidic monomers which are capable of being copolymerized with the particular copolymer system.

In order to modify or enhance certain properties of the amphoteric polymer, such as adhesion, compatibility, water solubility, hardness, flexibility and antistatic properties, any of the following acrylic and methacrylic comonomers can be used: acrylic and methacrylic acid esters of aliphatic alcohols having from 1 to 12 carbon atoms such as methyl, ethyl, propyl, butyl, octyl and lauryl alcohols; hydroxyalkyl esters of acrylic and methacrylic acids such as hydroxypropyl acrylate and methacrylate, hydroxybutyl acrylate and methacrylate, hydroxystearyl acrylate and methacrylate, and hydroxyethyl acrylate and methacrylate; alkyl (C₁-C₄) amino alkyl (C₂-C₄) esters of acrylic and methacrylic acids such as N, N'-diethylaminoethyl acrylate, N-tertiary-butylaminopropyl acrylate, N,N'-dimethylaminoethyl methacrylate, N-tertiary-butylaminoethyl methacrylate and the quaternization product of dimethylaminoethyl methacrylate and dimethyl sulfate and diethyl sulfate; diacetone acrylamide; vinyl esters such as vinyl acetate and vinyl propionate; and styrene monomers such as styrene and alpha-methyl styrene.

Preferred amphoteric copolymers are those containing from about 30-60% by weight of the N-substituted acrylamide or methacrylamide, from 10-20% by weight of the acidic comonomer, and up to 55% by weight of at least one copolymerizable comonomer; these percentages being based on the total weight of the copolymer.

Particularly preferred because they combine the best physical properties are those copolymers containing from 35-45% by weight of N-tertiary-octyl acrylamide, from 12-18% by weight of acrylic or methacrylic acid, from 32-38% by weight of methyl methacrylate, from 2-10% by weight of hydroxypropyl acrylate, and from 2-10% by weight of an alkyl (C₁-C₄) amino alkyl (C₂-C₄) acrylate or methacrylate.

Preparation of the above-described acrylic copolymers is described in U.S. Patent 3,927,199 to Micchelli et al.

### (b') Carboxylic Copolymer Binder

The carboxyl containing copolymer binder (b') used in the first layer of photoimageable permanent coating contains the monomer unit of the formula 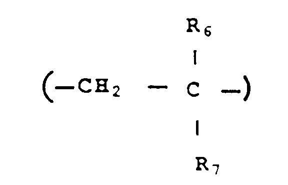 wherein R₆ is H or C₁₋₄ alkyl, R₇ is phenyl or -CO₂R₈; and R₈ is H or C₁₋₄ alkyl, which can be substituted with one or more hydroxy groups. Suitable comonomers which form the monomer unit of the copolymer include styrene and unsaturated carboxylic acids and their derivatives, such as (meth)acrylic acid and (meth)acrylates. Methyl methacrylate, methyl acrylate, ethyl acrylate, butyl acrylate, ethyl methacrylate, butyl methacrylate, 2-hydroxyethyl acrylate and 2-hydroxyethyl methacrylate are particularly preferred.

The carboxylic copolymer binder used in the first layer can be formed by direct copolymerization of one or more ethylenically unsaturated dicarboxylic acid anhydrides with one or more of the comonomers described above. Suitable ethylenically unsaturated dicarboxylic acid anhydrides are, for example, maleic anhydride, itaconic acid anhydride and citraconic acid anhydride. The copolymer binder containing acid anhydride functionality can be reacted with primary or secondary alcohols or amines.

When the permanent coating is photoprinted, development of the composition requires that the copolymer binder contains sufficient carboxylic acid groups to render the permanent coating processable in aqueous alkaline developer. The coating layer will be removed in portions which are not exposed to radiation but will be substantially unaffected in exposed portions during development by aqueous alkaline liquids, such as wholly aqueous solutions containing 1% sodium or potassium carbonate by weight for a time period of five minutes at a temperature of 40°C. The acid number of the copolymer binder used in the first photoimageable permanent coating layer should be 40 to 160, preferably 60 to 150, to also optimize adhesion to the printed circuit substrate.

In order to have sufficient conformability and resistance to drastic changes in environmental conditions, the permanent coating requires that the binder material have a glass transition temperature less than 100°C. The binder material for the first photoimageable permanent coating layer should have a glass transition temperature preferably from 30°C to 100°C. If the T_{g} of the binder material is less than 30°C, adherence to the support film can be too high for desired release.

The proper molecular weight range is required for manufacturing purposes, such as solution viscosity and process latitude, as well as for a proper balance of permanent coating properties, such as toughness and solder resistance. A copolymer binder molecular weight range of from about 25,000 to 500,000 is suitable. The preferred range is from about 40,000 to 250,000.

The quantity of total carboxylic copolymer binder present in the first photoimageable coating layer is generally 30 to 80% by weight relative to the total components of the permanent coating composition.

### (c') Ethylenically Unsaturated Monomer

The monomer used as a component of the first layer of photoimageable coating provides the capability of the permanent coating composition to photopolymerize and contributes to overall properties. In order to effectively do so, the monomer should contain at least two ethylenically unsaturated groups capable of undergoing polymerization on exposure to actinic radiation when incorporated in the permanent coating element. Excessive amounts of trifunctional acrylate monomers can result in reduction of required flexibility. It is desirable to have a relatively lower level of monomer concentration in the first permanent coating layer in order to ensure that adhesion of the first layer to the support film is not excessive.

Suitable monomers (c') which can be used as the sole monomer or in combination with others include acrylate and methacrylate derivatives of alcohols, isocyanates, esters, epoxides and the like. Examples are diethylene glycol diacrylate, trimethylolpropane triacrylate, pentaerythritol triacrylate, poly-oxyethylated and polyoxypropylated trimethylolpropane triacrylate and trimethacrylate and similar compounds as disclosed in U.S. Patent 3,380,831, di-(3-methacryloxy-2-hydroxypropyl) ether of tetrachloro-bisphenol-A, di-(2-methacryloxyethyl) ether of tetrachloro-bisphenol-A, di-(3-methacryloxy-2-hydroxypropyl) ether of tetrabromobisphenol-A, di-(2-methacryloxyethyl) ether of tetrabromo-bisphenol-A, triethylene glycol dimethacrylate, trimethylol propane triacrylate, polycaprolactone diacrylate, and aliphatic and aromatic urethane oligomeric di(meth)acrylates from Sartomer, West Chester, PA and Ebecryl® 6700 available from UCB Chemicals, Smyrna, GA.

A particularly preferred class of comonomers is hexamethylene glycol diacrylate, triethylene glycol diacrylate, tripropylene glycol diacrylate, trimethylolpropane triacrylate, polyoxyethylated trimethylolpropane triacrylate, polyoxypropylated trimethylolpropane triacrylate, pentaerythritol tri- and tetraacrylate, bisphenol-A diacrylate, di-(3-acryloxy-2-hydroxypropyl) ether of bisphenol-A, di-(3-acryloxy-2-hydroxypropyl) ether of tetrabromo-bisphenol-A, or methacrylate analogues thereof as well as aliphatic urethane diacrylates CN 961 and CN 964, and aromatic urethane diacrylates CN 971 and CN 972 available from Sartomer, West Chester, PA.

The quantity of total ethylenically unsaturated monomer (c') is generally 5 to 30% by weight relative to the total components of the first photoimageable permanent coating layer.

### (d') Photoinitiator System

From 0.01 to 10% by weight of a photoinitiator system as previously described hereinabove, is used in the first photoimageable coating layer. It is preferred to use a photoinitiator system in the first photoimageable coating layer that has an absorbence maximum at about the absorbence minimum for the second photoimageable layer. In this manner, sufficient incident exposure radiation will be able to pass through the second layer to expose the first layer in a similar time period as for the second layer.

A preferred photoimageable composition for use as the first coating layer comprises (a') from 5 to 25% by weight of an amphoteric copolymer binder of 40 weight % N-tertiary-octylacrylamide, 35 weight % methylmethacrylate, 16 weight % acrylic acid, 5 weight % hydroxypropyl methacrylate and 4 weight % tertiarybutyl-aminoethyl methacrylate having a weight average molecular weight (M_{w}) of 50,000 and an acid number of 118; (b') from 30 to 80% by weight of a copolymer binder of 51 weight % methyl methacrylate, 29 weight % ethyl acrylate and 20 weight % methacrylic acid having a weight average molecular weight (M_{w})of 40,000 and an acid number of 127; (c') from 5 to 30% by weight of trimethylolpropane triacrylate; and (d') from 0.01 to 10% by weight of a photoinitiator system.

### Permanent Coating Process

Photoimageable permanent coatings can be used as a solder mask to protect printed circuits during subsequent processing, primarily solder operations, and/or from environmental effects during use. Permanent coatings also are used as intermediate insulative layers, with or without development, in the manufacture of multilayer printed circuits.

In practice, the photoimageable coating or multilayer coating element with the photoimageable layers typically between 10 and 125 micrometers (0.4 and 5 mils) thick, are applied to a printed circuit substrate which typically is a printed circuit relief pattern on a substrate that is semi-rigid, such as fiberglass reinforced epoxy, or on a flexible film substrate based on polyimide or polyester film. The applied photopolymerizable, permanent coatings are then imagewise exposed to actinic radiation to harden or insolubilize exposed areas. Any unexposed areas are then completely removed typically with an alkaline, aqueous sodium or potassium carbonate developer solution which selectively dissolves, strips or otherwise disperses the unexposed areas without adversely affecting the integrity or adhesion of the exposed areas. The developed permanent resist image is first treated to further cure or harden it by baking at elevated temperatures, such as one hour at 160° C., by additional uniform exposure to actinic radiation or a combination thereof to produce a circuit board having a cured permanent resist layer covering all areas except unexposed areas that have been removed by development. Electrical components are then inserted into the through-holes or positioned on surface mount areas and soldered in place to form the packaged electrical component.

The photoimageable permanent coating may be applied to a printed circuit substrate either as a liquid or as a pre-formed dry film.

### Coating Liquids

The photoimageable, permanent coating may be coated as a liquid onto the printed circuit substrate using any conventional coating process. The liquid may be a solution or a dispersion of the permanent coating composition wherein the solvent is removed subsequent to coating to form a dry, solid, coverlay layer which, subsequent to coating, is directly imaged or exposed to actinic radiation to form a hardened coverlay layer. The liquids may be roller-coated, spin-coated, screen-coated or printed as disclosed in Coombs supra, in DeForest supra, in Lipson et al., U.S. Patent 4,064,287, or in Oddi et al., U.S. Patent 4,376,815. The liquid, typically as a solution, may also be curtain coated as disclosed in Losert et al., U.S. Patent 4,230,793. In the instance where printed circuits are manufactured on a continuous web of film substrate, permanent coating liquid may be coated by any conventional web coating process.

### Dry Film Lamination

A pre-formed, dry-film, photopolymerizable permanent coating layer is applied from a multi-ply, transfer, coverlay element using the lamination process as described in Celeste, U.S. Patent 3,469,982. The multi-ply, permanent coating element comprises, in order, an actinic-radiation transparent, temporary support film, e.g., polyethylene terephthalate or silicon treated polyethylene terephthalate, a thin photopolymerizable, permanent coating layer, and optionally a removable cover sheet, e.g., polyethylene or polypropylene, to protect the permanent coating element during storage. The photopolymerizable, permanent coating layer, is present in a range of thickness from 10 to 125 microns [µm] (0.4 to 5 mils) when used over printed circuit substrates. As described in Celeste supra, the cover sheet, if present, is first removed and the uncovered permanent coating surface is laminated to the precleaned copper printed circuit surface of the substrate using heat and/or pressure, e.g., with a conventional hot-roll laminator. Although the laminate is typically imagewise exposed to actinic radiation through the temporary support film, in some instances, the temporary support may be removed before imaging to improve resolution and other such properties. Typically, when a dry film is laminated to a printed circuit substrate having a low circuit relief, measures must be taken to eliminate entrapped air, e.g., from around circuit lines. Entrapped air is eliminated by the vacuum lamination process of Friel U.S. Patent 4,127,436, or by the grooved roll lamination process of Collier et al., U.S. Patent 4,071,367.

### Permanent Coating Evaluation

Printed circuits must withstand a variety of tests that are dependent on the application of the circuits, which in turn governs the type of material used as the circuit substrate. A stringent application is for flexible printed circuits which require a fold or bend for a particular space requirement, such as a camera or video cassette recorder (VCR), and may require the capability of surviving multiple bends, such as in a computer disc drive. In some applications a flexible circuit is combined with a rigid circuit to form a flex-rigid multilayer printed circuit. The end use tests for flexible circuits focus on adhesion and the capability to withstand single or multiple bends. In addition, accelerated aging is a useful test to simulate the practical concern of film aging on standing at ambient conditions for an extended period of time. The accelerated aging by exposure of the film to heat and humidity is effective for identifying film components that may oxidize or otherwise degrade more quickly than others. The tests that are used to support the Examples in this application are described hereinbelow.

### Time To Clear

This test evaluates the retention time for adequately developing coverlay. Coverlay is laminated onto a rigid substrate, then timed when placed through a 1% sodium carbonate or potassium carbonate developer solution (which should be at the same temperature as that used in actual processing, typically 40°C). The total "time to clear" is reported in seconds, beginning from the time the sample enters the developer and ending at the time at which the unexposed coverlay is washed off of the substrate.

### Photo Speed

This test evaluates the processability of coverlay. Green coverlay is laminated onto a substrate, then is exposed to 250 to 500 mj/cm² UV through a 21-step Stouffer sensitivity photopattern. After the sample is developed, the resulting step-wedge pattern is analyzed. Values are reported in a X-Y range, in which the X value is the last step in which no developer attack is noted and Y is the last step containing coverlay. The optimum exposure level is obtained at a y value of 10 to 12. High x values indicate low attack of the photopolymer by the developer.

### Encapsulation

This test evaluates the capability of coverlay to adequately protect the substrate. The substrate and coverlay chosen for this test should represent those in end-use applications. The substrate is typically a circuit pattern and is processed with the coverlay exactly as is done in actual manufacturing. After processing, the sample is evaluated using 10X magnification for any haloing, air entrapment, and/or delaminations, which constitute a failure. In addition, the sample also may be cross-sectioned along the edge of a circuit line and evaluated using magnification to ensure that coverlay adequately covers the area with no "soda-strawing" defects. Before samples are processed further they should pass this encapsulation test. All of the examples of the invention passed the encapsulation test.

### Cross-Hatch Adhesion

This test is performed according to ASTM D-3359-79, Method B. Test substrates are selected to duplicate the material typically used for end-use, and are processed to mirror actual processing.

Test substrates are either chemically cleaned substrates or substrates used without any pre-cleaning or etching of the copper surface. The samples that are chemically cleaned are cleaned in a series of steps with immersion first in Versa Clean® 415 for 2 minutes at 45° to 50°C followed by immersion for 30 seconds in a deionized water bath. The samples are then immersed in Sure Etch® 550 micro etching solution for one minute at 35°C, followed by a deionized water rinse for 30 seconds. The samples are finally immersed in 10% sulfuric acid solution at room temperature for 30 seconds and given a final deionized water rinse. Samples are dried and placed immediately in a nitrogen atmosphere until used.

The test areas are a blank copper area and a blank adhesive area. Specimens are tested "after cure" as well as "after solder" exposure, which simulates solder exposure during PCB fabrication. Typical "after solder" specimens are floated in 288°C 60/40 tin/lead solder for 30 seconds. Residual solder is then removed before evaluation. All specimens are scored with a 10 blade Gardco blade, then the sample is rotated 90° and rescored so that a cross-hatch pattern comprised of 100 squares is cut into the coverlay surface. Adhesive tape is applied and rubbed to ensure good contact, then pulled away at a 90° angle in a smooth fluid motion. The sample is examined using 10X magnification for defects, typically delamination or microcracks. Pick off from the cutting blade of 1-2% is not considered a failure but >2% pickoff is a failed sample.

### Bend & Crease

The substrate to be used for this test is typically a MIT flexural endurance pattern. The MIT pattern is a meander pattern that has alternating one mm lines and spaces in the region of the testing. The sample is creased perpendicular to the direction of the lines and spaces. The substrate is typically the same type as that used in the actual product application. The thickness and type of substrate (copper, adhesive) and the processing steps (pre-clean, lamination, cure, solder exposure) are duplicated so that the evaluation reflects a true simulation. Typically a Teclam® FNC9111 substrate is used with copper etched off of one side. Samples are bent and creased by hand 90° perpendicular to the lines and spaces in 10 different areas of each sample, then examined using 10X magnification for defects such as cracks or delaminations. Any reported defects constitute a failure. Samples are evaluated "after cure" and "after solder", in which case samples are floated, coverlay side up, in 288°C 60/40 tin/lead solder for 30 seconds, then cooled to room temperature and evaluated as described above.

### Chemical Resistance

This test is designed to analyze any degradation in film properties when exposed to chemicals in the photoimaging processing steps. Coverlay is processed on a circuit-patterned substrate (circuitry and substrate used should be of the same type as that found in actual use). Each sample is immersed for up to 15 minutes in a chemical typically used in processing. These chemicals include plating chemicals such as 10% NaOH, 10% HCl, 10% H₂SO₄ and cleaning solvents such as methyl ethyl ketone (MEK), trichloroethylene (TCE) and isopropanol (IPA). After immersion, each sample is examined using 10X magnification for defects such as delamination, wicking, embrittlement or solvent attack. Any defects found are reported as failures.

### Pencil Hardness

This test is designed to analyze changes in the hardness of the coverlay after exposure to isopropyl alcohol. Coverlay is processed onto a blank substrate. After curing, the substrate is evaluated for pencil hardness according to ASTM D-3363. The reported value is then compared with a substrate that was immersed in isopropanol for 10 minutes, blotted dry and evaluated using the same method.

### Flammability (UL94 Test)

Specimens were tested in accordance with the UL94 Thin Material Vertical Burning Test for classifying resist coating materials as 94VTM-0, 94VTM-1 or 94VTM-2. The 94VTM-0 classification is the best rating, indicating significantly reduced flammability.

### Elongation to Break

The coating is laminated on Teflon® sheet, exposed at 500 mj/sq cm imagewise to generate one-half inch wide strips, developed at 40°C for two times the time to clear, air dried and cured for one hour at 160°C. Samples tested as unconditioned material are placed into a zip-lock bag until testing. Samples that are conditioned are placed in a nitrogen-purged 100°C oven, the temperature is held for 30 to 60 minutes, and then the samples are allowed to slowly cool to room temperature over a three hour period. The samples are placed in a desiccator with a purge of dry nitrogen, and held in this dry condition until tested on an Instron tester according to ASTM D-882-83 (Method A). The percent elongation is computed from the stress-strain data using Instron software Series IX Automated Materials Testing System 1.02C.

### EXAMPLES

To further illustrate the invention, the following examples below are provided. Materials used for the examples are:

### Binders

- Brominated copolymer binder # 1: Copolymer of 59% ethyl acrylate, 25% dibromostyrene and 16% acrylic acid with a Tg ranging from 36° to 43°C, the weight average molecular weight (M_{w}) ranging from 95,000 to 160,000 and acid number of from 122 to 160, solution in 80/20 ethyl acetate/acetone.
- Brominated copolymer binder #2: Copolymer of 61.5% ethyl acrylate, 25% dibromostyrene and 13.5% acrylic acid with a T_{g} of 38°C, weight average molecular weight (M_{w}) of 112,800 and acid number of 101, solution in 80/20 ethyl acetate/acetone.
- Brominated copolymer binder #3: Copolymer of 68% ethyl acrylate, 25% dibromostyrene and 7% acrylic acid with a T_{g} of 30°C and weight average molecular weight (M_{w}) of 123,400 and dried from its aqueous latex.
- Elvacite® 2627: Copolymer of methyl methacrylate, ethyl acrylate and methacrylic acid (51/29/20) having a T_{g} of 87°C, weight average molecular weight (M_{w})of 40,000 and acid number of 127.
- Acrylic Polymer #1: Pentapolymer of N-tertiary-octylacrylamide, methyl methacrylate, acrylic acid, hydroxypropyl methacrylate, and tertiary-butylaminoethyl methacrylate (40/35/16/5/4) having a T_{g} of 120°C, a weight average molecular weight (M_{w}) of 50,000 and an acid number of 118.
- Carboset® 515: Acrylic acid containing polymer having a T_{g} of -14°C, a weight average molecular weight (M_{w}) of 7,000 and an acid number of 63 from B. F. Goodrich, Cleveland, OH.

### Urethane Acrylates

- Ebecryl® 6700: Urethane diacrylate from UCB Chemicals, Smyrna, GA.
- Purelast® 153: Urethane diacrylate from Polymer Systems Corp,. Orlando, FL.
- PRO1465: Brominated urethane acrylate based on dibromoneopentyl glycol, which is 10% by weight bromine from Sartomer Chemical Co, Inc., Exton PA.

### Thermal crosslinking Agents

- Blocked isocyanate #1: Hexamethylene diisocyanate based polyisocyanate blocked with methyl ethyl ketoxime and dissolved at 75% solids in ethyl acetate.

### Initiators

- o-Cl HABI: Hexaarylbiimidazole
- EMK: Ethyl Michler's Ketone
- Irgacure® 369: 2-Benzyl-2-(dimethylamino)-1-[4- (4-morpholinyl)phenyl]-1-butanone from CIBA-Geigy Corporation, Hawthorne, NY
- Ebecryl® P-36: Benzophenone derivative acrylate from UCB Chemicals, Smyrna, GA.

### Detackifiers

- PVP K-120: Polyvinylpyrrolidone from GAF Chemicals Corp., Texas City, TX.
- PVP K-90: Polyvinylpyrrolidone from GAF Chemicals Corp., Texas City, TX.

### Other Ingredients

- TMPTA: Trimethylolpropane triacrylate from UCB Chemicals Corp., Smyrna, GA.
- DayGlo® HMO22A19: Blue dye from Dayglo Corp., Cleveland, OH.
- 3-MT: 3-mercapto-1H-1,2,4-triazole from Esprit Chemical Co., Rockland, MA
- 5-ATT: 5-amino-1,3,4-thiadiazole-2-thiol

### Brominated Acrylated Monomer

- Brominated diacrylate monomer #1: Bis-(3-acryloyloxy-2-hydroxypropyl)ether of tetrabromobisphenol-A

### Brominated Reactive Additive

- PHT-4 Diol: 3,4,5,6-Tetrabromo-1,2-benzene dicarboxylic acid mixed esters with diethylene glycol and propylene glycol from Great Lakes Chemical Corp., West Lafayette, IN
- Saytex® RB-79: Diester/ether diol of tetrabromophthalic anhydride from Albemarie Corp., Baton Rouge, LA
- BA-50P™: Bis(2-hydroxyethyl ether) of tetrabromobisphenol A from Great Lakes Chemical Corp., West Lafayette, IN
- FR-522: 2,2-Bis(bromomethyl)-1,3-Propanediol from Ameribrom, Inc., New York, NY
- Brominated Modified Epoxy: Reaction product of Ameribrom® FM2104X with succinic anhydride resulting in a resin with 52.2 dry weight % bromine

### Brominated Non-Reactive Additives

- Pyronil® 45: Di-2-ethylhexyl tetrabromophthalate from Elf Atochem North America, Philadelphia, PA.
- Rheoflam® PB-460: Brominated Phosphate from FMC Corp., Philadelphia, PA.

The brominated modified epoxy used in Example 13 was prepared by heating a solution of 100 g Ameribrom brominated resin F3014 and 15.26 g of succinic anhydride in 100 g of toluene at reflux for 4 hrs. The toluene was removed using a rotary evaporator and the residue dissolved in ethyl acetate to give 46.1% solids.

### Permanent Coating Formation

The coating solutions were converted to dry film product using a machine coater. The liquid compositions were coated on a 1 mil [0.0254 mm] Mylar® polyethylene terephthalate support, using a doctor knife (Examples 1 to 9 and 13 to 14) or an extrusion die (Examples 10 to 12) to give approximately a 2 mil [0.0508 mm] thick dried film composition. In Examples 1 to 7 and 13-14, a three-zone dryer with each zone 15 feet [4.572 m] long and with dryer temperatures of 50°C, 98°C and 115°C and a line speed of 20 feet per minute [6.096 m per minute] was used. In Examples 8 and 9, a one-zone dryer with the zone 10 feet [3.048 m] long and with dryer temperature of 85°C and a line speed of 2 feet per minute [0.6096 feet per minute] was used. In Examples 10 to 12, a three-zone dryer with each zone 15 feet [4.572 m] long and with dryer temperatures of 70 to 80°C, 93 to 99°C, and 110-118°C was used, with a line speed of 25 feet per minute [7.62 m per minute]. Coating solution viscosities were measured using a Brookfield Viscometer with specific conditions given in the Examples (Model, Spindle, Speed in rpm).

### Sublayer Formation

A coating solution was prepared containing the following ingredients:

| | % by weight |
|---|---|
| Methanol | 75.20 |
| Water | 9.40 |
| Propylene Glycol Methyl Ether | 9.40 |
| Acrylic Polymer #1 | 1.02 |
| Elvacite® 2627 | 3.85 |
| 5-ATT | 0.01 |
| PVP K-90 | 0.48 |
| TMPTA | 0.48 |
| Irgacure® 369 | 0.16 |

The solution was extrusion die coated at a line speed of 40 feet per minute [12.192 m per minute] to a dry thickness of 0.07 micron [µm] in the coater described above on a 1 mil [0.0254 mm] Mylar® polyester support film, and the resultant sublayer coating was used in Example 12.

### Examples 1 to 3

Examples 1 to 3 illustrate flame-retardant compositions containing brominated copolymer binder, brominated diacrylate monomer, and different brominated reactive additives.

| Component | Example 1 | Example 2 | Example 3 |
|---|---|---|---|
| | (% by weight) | (% by weight) | (% by weight) |
| Methanol | 16.14 | 16.16 | 16.19 |
| | | | |
| Ethyl acetate | 27.93 | 27.97 | 28.03 |
| | | | |
| Ebecryl® 6700 75% in ethyl acetate | 7.38 | 7.39 | 7.41 |
| | | | |
| Brominated diacrylate monomer #1 | 8.76 | 8.77 | 8.79 |
| | | | |
| 3-MT | 0.08 | 0.08 | 0.08 |
| | | | |
| o-Cl HABI | 0.38 | 0.38 | 0.38 |
| | | | |
| Benzophenone | 1.18 | 1.18 | 1.18 |
| | | | |
| EMK | 0.05 | 0.05 | 0.05 |
| | | | |
| PVP K-120 | 1.14 | 1.15 | 1.15 |
| | | | |
| Brominated reactive additive PHT-4 Diol | 1.39 | - | - |
| | | | |
| Brominated reactive additive BA-50P™ | - | 1.27 | - |
| | | | |
| Brominated reactive additive FR-522 | - | - | 1.05 |
| | | | |
| Blocked isocyanate #1 | 4.99 | 4.99 | 5.00 |
| | | | |
| DayGlo® HM022A19 | 1.25 | 1.25 | 1.26 |
| | | | |
| | | | |
| Carboset® 515 75% in ethyl acetate | 2.34 | 2.34 | 2.35 |
| | | | |
| Brominated copolymer binder #1 (55% Solids, M_{w} of 121,000, Tg of 42°C, and Acid No. of 154) | 26.99 | 27.03 | 27.09 |
| | | | |
| Wt. % Br in Film | 15.9 | 15.9 | 16.0 |
| | | | |
| Adjusted to Coating Viscosity (cps) (RVT, #3, 20) | 1200 | 1200 | 1200 |
| | | | |

| Property | | | |
|---|---|---|---|
| Time-to-clear (sec) | 20 | 23 | 22 |
| Stepwedge response | 4-12 | 4-13 | 4-13 |
| Cure conditions | 160°C/1 hr | 160°C/1 hr | 160°C/1 hr |
| | | | |

| Bend & Crease | | | |
|---|---|---|---|
| Substrate: Pyralux® LF9110¹ with copper etched off one side and a MIT pattern on the other side of the laminate | | | |
| | | | |
| • After cure | Pass | Pass - 9/10 | Pass |
| • After solder | Pass | Pass | Pass |

| Cross-Hatch Adhesion | | | |
|---|---|---|---|
| Substrate: Pyralux® LF9110¹ that was chemically cleaned | | | |
| • After cure | Pass | Pass | Pass |
| • After solder | Pass | Pass | Pass |

| Flammability (UL-94 VTM-0) | | | |
|---|---|---|---|
| Substrate: TecLam™ FNCl11² with copper chemically etched off both sides | | | |
| • Result | VTM-0 | VTM-0 | VTM-0 |
| • Total Burn Time (sec) | 19 | 19 | 28 |

| Chemical Resistance | | | |
|---|---|---|---|
| Substrate: Chemically cleaned Pyralux® LF9110¹ | | | |
| • 10% H₂SO₄ | Pass | Pass | Pass |
| • Isopropyl Alcohol | Pass | Pass | Pass |
| • Methyl Ethyl Ketone | Pass | Pass | Pass |
| • 10% NaOH | Pass | Pass | Pass |

| Pencil Hardness Before/After IPA Soak | | | |
|---|---|---|---|
| • Before/After | HB/HB | HB/HB | HB/HB |

| | | | |
|---|---|---|---|
| 1 Pyralux® LF-9110 is a laminate of 1 mil Kapton® polyimide film, 1 mil acrylic adhesive and 1 oz/ft² copper foil, commercially available from E. I. du Pont de Nemours & Co. | | | |
| 2 TecLam™ FNC111 is a laminate material of 1 mil Kapton® polyimide film coated on two sides with 1 mil epoxy-based adhesive and cured with 1 oz/ft² copper foil laminated to the adhesive side, available from E. I. du Pont de Nemours & Co. | | | |

### Examples 4 to 6

Examples 4 to 6 illustrate flame-retardant coating compositions containing brominated copolymer monomer, brominated diacrylate monomer, and varying amounts of a brominated reactive additive and different film bromine contents.

| component | Example 4 | Example 5 | Example 6 |
|---|---|---|---|
| | (% by weight) | (% by weight) | (% by weight) |
| Methanol | 18.75 | 18.75 | 18.75 |
| | | | |
| Ethyl acetate | 14.86 | 14.59 | 14.59 |
| | | | |
| Ebecryl® 6700 75% in ethyl acetate | 8.55 | 9.66 | 10.90 |
| | | | |
| Brominated diacrylate monomer #1 75% in ethyl acetate | 12.40 | 12.40 | 11.16 |
| | | | |
| 3-MT | 0.09 | 0.09 | 0.09 |
| | | | |
| o-Cl HABI | 0.44 | 0.44 | 0.44 |
| | | | |
| Benzophenone | 1.35 | 1.35 | 1.35 |
| | | | |
| EMK | 0.06 | 0.06 | 0.06 |
| | | | |
| PVP K-120 | 1.35 | 1.35 | 1.35 |
| | | | |
| Brominated reactive additive PHT-4 Diol | 2.45 | 1.62 | 1.62 |
| | | | |
| Blocked isocyanate #1 | 5.75 | 5.75 | 5.75 |
| | | | |
| DayGlo® HM022A19 | 1.45 | 1.45 | 1.45 |
| | | | |
| Carboset® 515 75% in ethyl acetate | 2.72 | 2.72 | 2.72 |
| | | | |
| Brominated copolymer binder #1 (58% Solids, M_{w} of 121,000, Tg of 42°C, and Acid No. of 154) | 29.76 | 29.76 | 29.76 |
| | | | |
| Wt. % Br in Film | 16.0 | 15.2 | 14.4 |
| | | | |
| Adjusted to Coating Viscosity (cps) [x10⁻³ Pa s] (RVT, #3, 20) | 1250 | 1250 | 1250 |
| | | | |

| Property | | | |
|---|---|---|---|
| Time-to-clear (sec) | 19 | 19 | 19 |
| Stepwedge response | 1-11 | 3-12 | 4-12 |
| Cure conditions | 160°C/1 hr | 160°C/1 hr | 160°C/1 hr |
| | | | |

| Bend & Crease | | | |
|---|---|---|---|
| Substrate: Pyralux® LF9110¹ with copper etched off one side and a MIT pattern on the other side of the laminate | | | |
| | | | |
| • After cure | Pass | Pass | Pass |
| • After solder | Pass | Pass | Pass |
| | | | |

| Cross-Hatch Adhesion | | | |
|---|---|---|---|
| Substrate: Pyralux LF9110¹ that was chemically cleaned | | | |
| | | | |
| • After cure | Pass | Pass | Pass |
| • After solder | Pass | Pass | Pass |
| | | | |

| % Elongation to Break | | | |
|---|---|---|---|
| • Conditioned | 48 | 46 | 43 |
| | | | |

| Flammability (UL94 VTM-0) | | | |
|---|---|---|---|
| Substrate: TecLam™ FNC111² with copper chemically etched off both sides | | | |
| | | | |
| • Result | VTM-1 (retest) | VTM-0 | VTM-0 |
| • Total Burn Time (s) | 21 | 10 | 9 |
| | | | |

| Chemical Resistance | | | |
|---|---|---|---|
| Substrate: Chemically cleaned Pyralux® LF9110¹ | | | |
| | | | |
| • 10% H₂SO₄ | Pass | Pass | Pass |
| • Isopropyl Alcohol | Pass | Pass | Pass |
| • Methyl Ethyl Ketone | Pass | Pass | Pass |
| • 10% NaOH | Pass | Pass | Pass |

| Pencil Hardness Refore/After IPA Soak | | | |
|---|---|---|---|
| • Before/After | HB/HB | HB/HB | HB/HB |

| | | | |
|---|---|---|---|
| 1 Pyralux® LF-9110 is a laminate of 1 mil Kapton® polyimide film, 1 mil acrylic adhesive and 1 oz/ft² copper foil, commercially available from E. I. du Pont de Nemours & Co. | | | |
| 2 TecLam™ FNC111 is a laminate material of 1 mil Kapton® polyimide film coated on two sides with 1 mil epoxy-based adhesive and cured with 1 oz/ft² copper foil laminated to the adhesive side, available from E. I. du Pont de Nemours & Co. | | | |

### Example 7

Example 7 illustrates a flame-retardant coating composition containing a brominated copolymer binder with lower acid content compared to that in Examples 1 to 6.

| Component | Example 7 |
|---|---|
| | (% by weight) |
| Methanol | 16.14 |
| | |
| Ethyl acetate | 27.93 |
| | |
| Ebecryl® 6700 75% in ethyl acetate | 7.38 |
| | |
| Brominated diacrylate monomer #1 | 8.76 |
| | |
| 3-MT | 0.08 |
| | |
| o-Cl HABI | 0.38 |
| | |
| Benzophenone | 1.18 |
| | |
| EMK | 0.05 |
| | |
| PVP K-120 | 1.14 |
| | |
| Brominated reactive additive PHT-4 Diol | 1.39 |
| | |
| Blocked isocyanate #1 | 4.99 |
| | |
| DayGlo® HM022A19 | 1.25 |
| | |
| Carboset® 515 75% in ethyl acetate | 2.34 |
| | |
| Brominated copolymer binder #2 (55% Solids) | 26.99 |
| | |
| Wt. % Br in Film | 15.9 |
| | |
| Adjusted to Coating Viscosity (cps) (RVT, #3, 20) | 1300 |
| | |

| Property | |
|---|---|
| Time-to-clear (sec) | 23 |
| | |
| Stepwedge response | 4-13 |
| Cure conditions | 160°C/1 hr |
| | |
| | |

| Bend & Crease | |
|---|---|
| Substrate: Pyralux® LF9110¹ with copper etched off one side and a MIT pattern on the other side of the laminate | |
| | |
| • After cure | Pass |
| • After solder | Pass |
| | |

| Cross-Hatch Adhesion | |
|---|---|
| Substrate: Pyralux® LF9110¹ that was chemically cleaned | |
| | |
| • After cure | Pass |
| • After solder | Pass |
| | |

| Flammability (UL94VTM-0) | |
|---|---|
| Substrate: TecLam™ FNC111² with copper chemically etched off both sides | |
| | |
| • Result | VTM-0 |
| • Total Burn Time (sec) | 23 |
| | |

| Chemical Resistance | |
|---|---|
| Substrate: Chemically cleaned Pyralux® LF9110¹ | |
| | |
| • 10% H₂SO₄ | Pass |
| • Isopropyl Alcohol | Pass |
| • Methyl Ethyl Ketone | Pass |
| • 10% NaOH | Pass |

| Pencil Hardness Before/After IPA Soak | |
|---|---|
| • Before/After | HB/HB |

| | |
|---|---|
| 1 Pyralux® LF-9110 is a laminate of 1 mil Kapton® polyimide film, 1 mil acrylic adhesive and 1 oz/ft² copper foil, commercially available from E. I. du Pont de Nemours & Co. | |
| 2 TecLam" FNC111 is a laminate material of 1 mil Kapton® polyimide film coated on two sides with 1 mil epoxy-based adhesive and cured with 1 oz/ft² copper foil laminated to the adhesive side, available from E. I. du Pont de Nemours & Co. | |

### Examples 8 and 9

Examples 8 and 9 illustrate flame-retardant coating compositions containing brominated copolymer binder, brominated diacrylate monomer and different brominated non-crosslinkable additives.

| Component | Example 8 (% by weight) | Example 9 (% by weight) |
|---|---|---|
| Methanol | 12.91 | 15.44 |
| | | |
| Ethyl acetate | 25.82 | 30.87 |
| | | |
| Acetone | - | 3.40 |
| | | |
| Toluene | 16.64 | - |
| | | |
| Ebecryl® 6700 75% in ethyl acetate | 8.78 | 8.95 |
| | | |
| Brominated diacrylate monomer #1 | 7.58 | 8.34 |
| | | |
| 3-MT | 0.08 | 0.08 |
| | | |
| o-Cl HABI | 0.46 | 0.40 |
| | | |
| Benzophenone | 1.18 | 1.23 |
| | | |
| EMK | 0.05 | 0.05 |
| | | |
| | | |
| PVP K-120 | 1.26 | 1.20 |
| | | |
| Brominated non-reactive additive Rheoflam® PB-460 | 4.16 | - |
| | | |
| Brominated non-reactive additive Pyronil® 45 | - | 7.72 |
| | | |
| Blocked isocyanate #1 | 4.88 | 5.25 |
| | | |
| DayGlo® HM022A19 | 1.23 | 1.33 |
| | | |
| Carboset® 515 | 1.86 | 1.85 |
| | | |
| Brominated copolymer binder #3 | 13.11 | 13.89 |
| | | |
| Wt. % Br in Film | 15.4 | 16.6 |
| | | |
| Adjusted to Coating Viscosity (cps) | 2300 | 1600 |
| | | |

| Property | | |
|---|---|---|
| Time-to-clear (sec) | 52 | 49 |
| Stepwedge response | 8 | 7 |
| Cure conditions | 160°C/1 hr | 160°C/1 hr |
| | | |

| Bend & Crease | | |
|---|---|---|
| Substrate: Pyralux® LF9110¹ with copper etched off one side and a MIT pattern on the other side of the laminate | | |
| | | |
| • After cure | Pass | Pass |
| • After solder | Pass | Not Pass |
| | | |

| Cross-Hatch Adhesion | | |
|---|---|---|
| Substrate: Pyralux® LF9110¹ that was chemically cleaned | | |
| | | |
| • After cure | Pass | - |
| • After solder | Pass | - |
| | | |

| Flammability (UL94VTM-0) | | |
|---|---|---|
| Substrate: TecLam™ FNC111² with copper chemically etched off both sides | | |
| | | |
| • Result | VTM-0 | VTM-0 |
| • Total Burn Time (sec) | 17 | 17 |

| | | |
|---|---|---|
| 1 Pyralux® LF-9110 is a laminate of 1 mil Kapton® polyimide film, 1 mil acrylic adhesive and 1 oz/ft² copper foil, commercially available from E. I. du Pont de Nemours & Co. | | |
| 2 TecLam™ FNC111 is a laminate material of 1 mil Kapton® polyimide film coated on two sides with 1 mil epoxy-based adhesive and cured with 1 oz/ft² copper foil laminated to the adhesive side, available from E. I. du Pont de Nemours & Co. | | |

### Example 10

Example 10 illustrates a preferred flame-retardant photoimageable coating composition of the invention.

| Component | Example 10 |
|---|---|
| | (% by weight) |
| Methanol | 17.79 |
| | |
| Ethyl acetate | 9.91 |
| | |
| Ebecryl® 6700 75% in ethyl acetate | 10.59 |
| | |
| Brominated diacrylate monomer #1 75% in ethyl acetate | 13.61 |
| | |
| 3-MT | 0.10 |
| | |
| o-Cl HABI | 0.25 |
| | |
| Benzophenone | 1.48 |
| | |
| EMK | 0.06 |
| | |
| PVP K-90 | 1.48 |
| | |
| Brominated reactive additive PHT-4 Diol | 1.78 |
| | |
| Blocked isocyanate #1 | 6.33 |
| | |
| DayGlo® HM022A19 | 1.59 |
| | |
| Carboset® 515 | 2.24 |
| | |
| Brominated copolymer binder #1 (57.8% Solids) | 32.78 |
| | |
| Wt. % Br in Film | 15.2 |
| | |
| Adjusted to Coating Viscosity (cps) [x10⁻³ Pa s] (DV-I+, #2, 20) | 1070 |
| | |

| Property | |
|---|---|
| Time-to-clear (sec) | 14 |
| Stepwedge response | 3-11 |
| Cure conditions | 160°C/1 hr |
| | |

| Bend & Crease | |
|---|---|
| Substrate: Pyralux® LF9110¹ with copper etched off one side and a MIT pattern on the other side of the laminate | |
| | |
| • After cure | Pass |
| • After solder | Pass |
| | |

| Cross-Hatch Adhesion | |
|---|---|
| Substrate: Pyralux® LF9110¹ that was chemically cleaned | |
| | |
| • After cure | Pass |
| • After solder | Pass |
| | |

| % Elongation to Break | |
|---|---|
| • Conditioned | 90 |
| | |

| Flammability (UT.94VTM-0) | |
|---|---|
| Substrate: TecLam™ FNC111² with copper chemically etched off both sides | |
| | |
| • Result | VTM-0 |
| • Total Burn Time (sec) | 34 |

| Chemical Resistance | |
|---|---|
| Substrate: Chemically cleaned Pyralux® LF9110¹ | |
| | |
| • 10% H₂SO₄ | Pass |
| • Isopropyl Alcohol | Pass |
| • Methyl Ethyl Ketone | Pass |
| • 10% NaOH | Pass |
| | |

| Pencil Hardness Before/After IPA Soak | |
|---|---|
| • Before/After | HB/2B |

| | |
|---|---|
| 1 Pyralux® LF-9110 is a laminate of 1 mil Kapton® polyimide film, 1 mil [0.0254 mm] acrylic adhesive and 1 oz/ft² [0.305 kg m⁻²] copper foil, commercially available from E. I. du Pont de Nemours & Co. | |
| 2 TecLam™ FNC111 is a laminate material of 1 mil [0.0254 mm] Kapton® polyimide film coated on two sides with 1 mil [0.0254 mm] epoxy-based adhesive and cured with 1 oz/ft² [0.305 kg m⁻²] copper foil laminated to the adhesive side, available from E. I. du Pont de Nemours & Co. | |

### Examples 11 and 12

Examples 11 and 12 illustrate a flame-retardant, coating composition of the invention with and without a low tack sublayer. Example 11 was coated on 1 mil [0.0254 mm] Mylar® polyethylene terephthalate film, and Example 12 was coated on 1 mil [0.0254 mm] Mylar® polyethylene terephthalate film that had previously been coated with 0.07 micron [µm] low tack sublayer as described above.

| Component | Example 11 | Example 12 |
|---|---|---|
| | (% by weight) | (% by weight) |
| Methanol | 19.24 | 19.24 |
| | | |
| Ethyl acetate | 16.48 | 16.48 |
| | | |
| Ebecryl® 6700 75% in ethyl acetate | 8.28 | 8.28 |
| | | |
| Brominated diacrylate monomer #1 75% in ethyl acetate | 13.07 | 13.07 |
| | | |
| 3-MT | 0.09 | 0.09 |
| | | |
| o-Cl HABI | 0.43 | 0.43 |
| | | |
| Benzophenone | 1.30 | 1.30 |
| | | |
| EMK | 0.05 | 0.05 |
| | | |
| PVP K-120 | 1.30 | 1.30 |
| | | |
| Brominated reactive additive PHT-4 Diol | 1.57 | 1.57 |
| | | |
| Blocked isocyanate #1 | 5.58 | 5.58 |
| | | |
| DayGlo® HM022A19 | 1.39 | 1.39 |
| | | |
| Carboset® 515 | 1.98 | 1.98 |
| | | |
| | | |
| Brominated copolymer binder #1 (57.1% Solids) | 29.23 | 29.23 |
| | | |
| Wt. % Br in Film | 15.9 | 15.9 |
| Adjusted to Coating Viscosity (cps) (DV-I+, #2, 12) | 1600 | 1600 |
| | | |

| Property | | |
|---|---|---|
| Time-to-clear (sec) | 18 | 18 |
| Stepwedge response | 3-11 | 4-13 |
| Cure conditions | 160°C/1 hr | 160°C/1 hr |
| | | |

| Bend & Crease | | |
|---|---|---|
| Substrate: Pyralux® LF9110¹ with copper etched off one side and a MIT pattern on the other side of the laminate | | |
| | | |
| • After cure | Pass - 9/10 | Pass |
| • After solder | Pass | Pass |
| | | |

| Cross-Hatch Adhesion | | |
|---|---|---|
| Substrate: Pyralux® LF9110¹ that was chemically cleaned | | |
| | | |
| • After cure | Pass | Pass |
| • After solder | Pass | Pass |
| | | |

| % elongation to Break | | |
|---|---|---|
| • Conditioned | 16 | 21 |
| | | |

| Flammability (UL94VTM-0) | | |
|---|---|---|
| Substrate: TecLam™ FNC111² with copper chemically etched off both sides | | |
| | | |
| • Result | Pass | Pass |
| • Total Burn Time (s) | 26 | 22 |
| | | |

| Chemical Resistance | | |
|---|---|---|
| Substrate: Chemically cleaned Pyralux® LF9110¹ | | |
| | | |
| • 10% H₂SO₄ | Pass | Pass |
| • Isopropyl Alcohol | Pass | Pass |
| • Methyl Ethyl Ketone | Pass | Pass |
| • 10% NaOH | Pass | Pass |
| | | |

| Pencil Hardness Before/After IPA Soak | | |
|---|---|---|
| • Before/After | HB/HB | HB/HB |

| | | |
|---|---|---|
| 1 Pyralux® LF-9110 is a laminate of 1 mil [0.0254 mm] Kapton® polyimide film, 1 mil [0.0254 mm] acrylic adhesive and 1 oz/ft² [0.305 kg m⁻²] copper oil, commercially available from E. I. du Pont de Nemours & Co. | | |
| 2 TecLam® FNC111 is a laminate material of 1 mil [0.0254 mm] Kapton® polyimide film coated on two sides with 1 mil [0.0254 mm] epoxy-based adhesive and cured with 1 oz/ft² [0.305 kg m⁻²] copper foil laminated to the adhesive side, available from E. I. du Pont de Nemours & Co. | | |

### Examples 13 and 14

Examples 13 and 14 illustrate flame-retardant coating compositions containing a brominated modified epoxy monomer and a brominated urethane acrylate to improve flame retardancy.

| Component | Example 13 | Example 14 |
|---|---|---|
| | (% by weight) | (% by weight) |
| Methanol | 16.26 | 16.08 |
| | | |
| Ethyl acetate | 12.14 | 14.07 |
| | | |
| Brominated diacrylate monomer #1 | 9.81 | 13.49 |
| | | |
| Brominated urethane diacrylate PRO-1465 | - | 3.51 |
| | | |
| Urethane diacrylate Pure last® 153 | 8.18 | 3.51 |
| | | |
| 3-MT | 0.11 | 0.11 |
| | | |
| o-Cl HABI | 0.27 | 0.27 |
| | | |
| Ebecryl® P-36 | 1.47 | 1.46 |
| | | |
| EMK | 0.05 | 0.05 |
| | | |
| PVP K-120 | 1.64 | 1.62 |
| | | |
| Blocked isocyanate #1 | 6.54 | 6.47 |
| | | |
| Brominated copolymer binder #1 (50.0% solids) | 24.46 | 28.56 |
| | | |
| Sevron Blue GMF | 0.04 | 0.02 |
| | | |
| Carboset® 515 | 2.72 | 1.62 |
| | | |
| TMPTA | 2.18 | 2.16 |
| | | |
| Brominated modified epoxy | 5.92 | - |
| | | |
| Saytex® RB79 | 8.18 | 7.01 |
| | | |

| Property | | |
|---|---|---|
| Time-to-clear (s) | 32 | 36 |
| Stepwedge response | 5-12 | 2-11 |
| Cure conditions | 160°C/1 h | 160°C/1 h |
| | | |
| Wt % Br in Film | 21.1 | 21.6 |
| Adjusted to Coating Viscosity (cps) [x10⁻³ Pa s] (RTV, #3, 20) | 1200 | 1075 |
| | | |

| Bend & Crease | | |
|---|---|---|
| Substrate: Pyralux® LF9110¹ with copper etched off one side and a MIT pattern on the other side of the laminate | | |
| | | |
| • After cure | Pass | Pass |
| • After solder | Pass | Pass |
| | | |

| Cross-Hatch Adhesion | | |
|---|---|---|
| Substrate: Pyralux® LF9110¹ that was chemically cleaned | | |
| | | |
| • After cure | Pass | Pass |
| • After solder | Pass | Pass |
| | | |
| Substrate: Pyralux® AP9121³ that was chemically cleaned | | |
| | | |
| • After cure | Pass | - |
| • After solder | Pass | - |
| | | |

| Flammability (UL94VTM-0) | | |
|---|---|---|
| Substrate: double side etched Pyralux® AP125EKJ⁴ | | |
| | | |
| • After cure | Pass V-0 | Pass V-1 |
| | | |

| % Elongation to Break | | |
|---|---|---|
| • Conditioned | 51 | 9 |
| | | |

| Pencil hardness before/after IPA Soak | | |
|---|---|---|
| • Before/after | HB/HB | HB/HB |

| | | |
|---|---|---|
| 1 Pyralux® LF-9110 is a laminate of 1 mil [0.0254 mm] Kapton® polyimide film, 1 mil [0.0254 mm] acrylic adhesive and 1 oz/ft² [0.305 kg m⁻²] copper foil, commercially available from E. I. du Pont de Nemours & Co. | | |
| 3 Pyralux® AP9121 is an all polyimide double side laminate of 2 mil [0.0508 mm] polyimide film and 1 oz/ft² [0.305 kg m⁻²] of copper foil on both sides. | | |
| 4 Pyralux® AP125SEKJ is an all polyimide double side laminate of 1.25 mil [0.0318 mm] polyimide film and 0.5 oz/ft² [0.153 kg m⁻²] of copper foil on both sides. | | |

## Claims

1. A flexible, flame-retardant, photoimageable resin composition for forming a permanent, protective coating on a flexible printed circuit board comprising:
(a) a brominated carboxylic copolymer binder comprising ring-brominated aromatic monomer units, alkyl acrylate, alkyl methacrylate or non-brominated aromatic monomer units, wherein alkyl contains from 1 to 20 carbon atoms, and ethylenically unsaturated carboxylic acid monomer units and having a weight average molecular weight (M_{w}) of from 40,000 to 500,000 and containing from 3 to 50% bromine by weight;
(b) a non-brominated carboxylic copolymer binder having a weight average molecular weight (M_{w}) of from 3,000 to 15,000 comprising from 2 to 50% by weight of at least one carboxylic acid containing monomer unit and from 50 to 98% by weight of at least one monomer unit of the formula 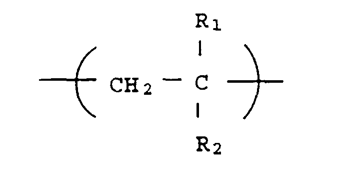 wherein R is H, C₁₋₄ alkyl or aryl; R₂ is H, CH₃, aryl, -COOR₃, - -CONR₄R₅ or -CN; and R₃, R₄ and R₅ are H, C₁₋₄ alkyl, aryl or C₁₋₄ alkyl or aryl substituted with one or more hydroxy, ester, keto, ether or thioether groups;
(c) an acrylated urethane monomeric component containing from 0 to 20% bromine by weight;
(d) optionally a brominated acrylated monomer containing from 10 to 80% bromine by weight with the proviso that (d) is not a urethane monomeric component;
(e) optionally a non-reactive or reactive brominated additive containing from 10 to 85% bromine by weight with the proviso that (e) is not an acrylated monomeric component or a blocked polyisocyanate crosslinking agent;
(f) a photoinitiator or a photoinitiator system; and
(g) a blocked polyisocyanate crosslinking agent containing from 0 to 30% bromine by weight,
wherein the total content of bromine in the composition ranges from 5 to 50% by weight.

2. The flexible, flame-retardant, photoimageable resin composition of Claim 1 comprising, based on the total weight of the composition, from 10 to 60% by weight of the brominated carboxylic copolymer binder (a); from 2 to 15% by weight of the non-brominated carboxylic copolymer binder (b); from 5 to 30% by weight of the acrylated urethane monomeric component (c); from 0 to 40% by weight of the brominated acrylated monomer (d); from 0 to 40% by weight of the non-reactive or reactive brominated additive (e); from 0.01 to 10% by weight of the photoinitiator system (f); and from 2 to 20% by weight of the blocked polyisocyanate crosslinking agent (g).

3. The flexible, flame-retardant, photoimageable resin composition of Claim 1 wherein the brominated carboxylic copolymer binder (a) comprises, the polymerized reaction product of from 5 to 55% by weight of ring-brominated aromatic monomer units, from 20 to 92% by weight of alkyl acrylate, alkyl methacrylate or non-brominated aromatic monomer units and from 3 to 25% by weight of ethylenically unsaturated carboxylic acid monomer units, based on the total weight of the copolymer.

4. The flexible, flame-retardant, photoimageable resin composition of Claim 3 wherein the ring-brominated aromatic monomer comprises mono, di, tri, or tetra bromine substituted styrene, methylstyrene, alpha-methylstyrene, alpha-methyl methylstyrene, ethylstyrene or alpha-methyl ethylstyrene.

5. The flexible, flame-retardant, photoimageable resin composition of Claim 1 wherein the non-brominated carboxylic copolymer binder (b) comprises the polymerized reaction product of an ethylenically unsaturated carboxylic acid and a comonomer of styrene or esters or amides of acrylic and methacrylic acid.

6. The flexible, flame-retardant, photoimageable resin composition of Claim 1 wherein the acrylated urethane monomeric component (c) is a urethane diacrylate comprising the reaction product of 2,6-toluene diisocyanate with a polyol with the end isocyanate groups end-capped with hydroxyethyl acrylate.

7. The flexible, flame-retardant, photoimageable resin composition of Claim 1 wherein the acrylated urethane monomeric component (c) is a brominated urethane diacrylate comprising the reaction product of dibromoneopentyl glycol with hexamethylene diisocyanate and end-capped with hydroxyethyl acrylate.

8. The flexible, flame-retardant, photoimageable resin composition of Claim 1 wherein the acrylated urethane monomeric component (c) is a brominated urethane diacrylate comprising the reaction product of bis(2-hydroxyethylether) of tetrabromobisphenol-A with hexamethylene diisocyanate and end-capped with hydroxyethyl acrylate.

9. The flexible, flame-retardant, photoimageable resin composition of Claim 1 wherein the acrylated urethane monomeric component (c) is a brominated urethane diacrylate comprising the reaction product of dibromoneopentyl glycol and polyols with aliphatic or aromatic diisocyanates and end-capped with hydroxyethyl acrylate.

## Patentansprüche

1. Flexible, flammenhemmende Harzzusammensetzung, die ein photographisches Bild empfangen kann, zum Ausbilden eines permanenten Schutzüberzugs auf einer flexiblen Leitungsplatte, umfassend:
(a) ein bromiertes Carbonsäurecopolymer-Bindemittel, das ringbromierte aromatische Monomereinheiten, Alkylacrylat, Alkylmethacrylat oder nicht-bromierte aromatische Monomereinheiten, wobei der Alkylrest 1 bis 20 Kohlenstoffatome enthält, und ethylenisch ungesättigte Carbonsäuremonomer-Einheiten umfaßt, und das eine massegemittelte Molekülmasse (M_{w}) von 40000 bis 500000 aufweist und 3 bis 50 Gew.-% Brom enthält;
(b) ein nicht-bromiertes Carbonsäurecopolymer-Bindemittel mit einer massegemittelten Molekülmasse (M_{w}) von 3000 bis 15000, das 2 bis 50 Gew.-% mindestens einer eine Carbonsäure enthaltenden Monomereinheit und 50 bis 98 Gew.-% mindestens einer Monomereinheit der Formel 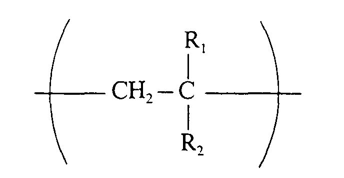 umfaßt, worin R H, C₁₋₄-Alkyl oder Aryl ist; R₂ H, CH₃, Aryl, -COOR₃, -CONR₄R₅ oder -CN ist; und R₃, R₄ und R₅ H, C₁₋₄-Alkyl, Aryl oder C₁₋₄-Alkyl oder Aryl, das mit einer oder mehreren Hydroxy-, Ester-, Keto-, Ether- oder Tioethergruppen substituiert ist, sind;
(c) eine monomere Acrylurethan-Komponente, die 0 bis 20 Gew.-% Brom enthält;
(d) gegebenenfalls ein bromiertes Acrylmonomer, das 10 bis 80 Gew.-% Brom enthält, mit der Maßgabe, daß (d) keine monomere Acrylurethan-Komponente ist;
(e) gegebenenfalls ein nicht-reaktives oder reaktives bromiertes Additiv, das 10 bis 85 Gew.-% Brom enthält, mit der Maßgabe, daß (e) nicht eine monomere Acrylkomponente oder ein blockiertes Polyisocyanat-Vernetzungsmittel ist;
(f) einen Photoinitiator oder ein Photoinitiatorsystem; und
(g) ein blockiertes Polyisocyanat-Vernetzungsmittel, das 0 bis 30 Gew.-% Brom enthält,
wobei der Gesamtgehalt an Brom in der Zusammensetzung im Bereich von 5 bis 50 Gew.-% liegt.

2. Flexible, flammenhemmende Harzzusammensetzung, die ein photographisches Bild empfangen kann, nach Anspruch 1, welche, bezogen auf das Gesamtgewicht der Zusammensetzung, 10 bis 60 Gew.-% des bromierten Carbonsäurecopolymer-Bindemittels (a); 2 bis 15 Gew.-% des nicht-bromierten Carbonsäurecopolymer-Bindemittels (b); 5 bis 30 Gew.-% der momomeren Acrylurethankomponente (c); 0 bis 40 Gew.-% des bromierten Acrylmonomers (d); 0 bis 40 Gew.-% des nichtreaktiven oder reaktiven bromierten Additivs (e); 0,01 bis 10 Gew.-% des Photoinitiatorsystems (f); und 2 bis 20 Gew.-% des blockierten Polyisocyanat-Vernetzungsmittels (g) umfaßt.

3. Flexible, flammenhemmende Harzzusammensetzung, die die ein photographisches Bild empfangen kann, nach Anspruch 1, wobei das bromierte Carbonsäurecopolymer-Bindemittel (a) das polymerisierte Reaktionsprodukt aus 5 bis 55 Gew.-% ringbromierten aromatischen Monomereinheiten, 20 bis 92 Gew.-% Alkylacrylat, Alkylmethacrylat oder nicht-bromierte aromatische Monomereinheiten und 3 bis 25 Gew.-% ethylenisch ungesättigte Carbonsäuremonomer-Einheiten, bezogen auf das Gesamtgewicht des Copolymers, umfaßt.

4. Flexible, flammenhemmende Harzzusammensetzung, die die ein photographisches Bild empfangen kann, nach Anspruch 3, wobei das ringbromierte aromatische Mono-, Di-, Tri- oder Tetrabrom-substituiertes Styrol, Methylstyrol, alpha-Methylstyrol, alpha-Methylmethylstyrol, Ethylstyrol oder alpha-Methylethylstyrol umfaßt.

5. Flexible, flammenhemmende Harzzusammensetzung, die ein photographisches Bild empfangen kann, nach Anspruch 1, wobei das nicht-bromierte Carbonsäurecopolymer-Bindemittel (b) das polymerisierte Reaktionsprodukt einer ethylenisch ungesättigten Carbonsäure und einem Comonomer aus Styrol oder Estem oder Amiden von Acryl- und Methacrylsäure umfaßt.

6. Flexible, flammenhemmende Harzzusammensetzung, die ein photographisches Bild empfangen kann, nach Anspruch 1, wobei die monomere Acrylurethankomponente (c) ein Urethandiacrylat ist, das das Reaktionsprodukt von 2,6-Toluoldiisocyanat mit einem Polyol umfaßt, wobei die Isocyanatendgruppen mit Hydroxyethylacrylat abgedeckelt sind.

7. Flexible, flammenhemmende Harzzusammensetzung, die ein photographisches Bild empfangen kann, nach Anspruch 1, wobei die monomere Acrylurethankomponente (c) ein bromiertes Urethandiacrylat ist, das das Reaktionsprodukt von Dibromneopentylglycol mit Hexamethylendiisocyanat umfaßt, und mit Hydroxyethylacrylat abgedeckelt ist.

8. Flexible, flammenhemmende Harzzusammensetzung, die ein photographisches Bild empfangen kann, nach Anspruch 1, wobei die monomere Acrylurethankomponente (c) ein bromiertes Urethandiacrylat ist, das das Reaktionsprodukt von Bis(2-hydroxyethylether) von Tetrabrombisphenol-A mit Hexamethylendiisocyanat umfaßt, und mit Hydroxyethylacrylat abgedeckelt ist.

9. Flexible, flammenhemmende Harzzusammensetzung, die photographisches Bild empfangen kann, nach Anspruch 1, wobei die monomere Acrylurethankomponente (c) ein bromiertes Urethandiacrylat ist, das das Reaktionsprodukt von Dibromneopentylglycol und Polyolen mit aliphatischen oder aromatischen Diisocyanaten umfaßt, und mit Hydroxyethylacrylat abgedeckelt ist.

## Revendications

1. Composition de résine flexible, ignifuge, exposable selon une image pour former un revêtement protecteur permanent sur une carte de circuit imprimé flexible comprenant :
(a) un liant copolymère carboxylique bromé comprenant des unités monomères aromatiques bromées sur le cycle, de l'acrylate d'alkyle, du méthacrylate d'alkyle ou des unités monomères aromatiques non bromées, dans lequel un alkyle contient de 1 à 20 atomes de carbone, et des unités monomères acide carboxylique éthyléniquement insaturées et ayant un poids moléculaire moyen (M_{w}) de 40000 à 500 000 et contenant de 3 à 50% en poids de brome;
(b) un liant copolymère carboxylique non bromé ayant un poids moléculaire moyen (M_{w}) de 3000 à 15 000 comprenant de 2 à 50% en poids d'au moins une unité monomère contenant un acide carboxylique et de 50 à 98% en poids d'au moins une unité monomère de formule 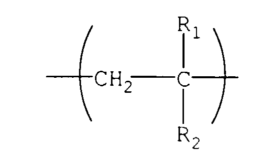 dans laquelle R est H, un alkyle en C₁-C₄ ou un aryle; R₂ est H, CH₃, un aryle, -COOR₃, -CONR₄R₅ ou -CN; et R₃, R₄, et R₅ sont H, un alkyle en C₁-C₄, un aryle ou un alkyle C₁-C₄ ou un aryle substitué avec un ou plusieurs groupements hydroxyle, ester, céto, éther ou thioéther; (c) un composant monomère uréthane acrylé contenant de 0 à 20% en poids de brome;
(d) facultativement un monomère acrylé bromé contenant de 10 à 80% en poids de brome à condition que (d) ne soit pas un composant monomère uréthane;
(e) facultativement un additif bromé non réactif ou réactif contenant de 10 à 85% en poids de brome à condition que (e) ne soit pas un composant monomère acrylé ou un agent de réticulation polyisocyanate bloqué;
(f) un photoinitiateur ou un système photoinitiateur, et
(g) un agent de réticulation polyisocyanate bloqué contenant de 0 à 30% en poids de brome,
dans laquelle le contenu total de brome dans la composition varie de 5 à 50% en poids.

2. Composition de résine flexible, ignifuge, exposable selon une image suivant la revendication 1, comprenant sur base du poids total de la composition, de 10 à 60% en poids du liant copolymère carboxylique bromé (a); de 2 à 15% en poids du liant copolymère carboxylique non bromé (b); de 5 à 30% en poids du composant monomère uréthane acrylé (c); de 0 à 40% en poids du monomère acrylé bromé (d); de 0 à 40% en poids de l'additif bromé non réactif ou réactif (e); de 0,01 à 10% en poids du système photoinitiateur (f); et de 2 à 20% en poids de l'agent de réticulation polyisocyanate bloqué (g).

3. Composition de résine flexible, ignifuge, exposable selon une image suivant la revendication 1, dans laquelle le liant copolymère carboxylique bromé (a) comprend le produit réactionnel polymérisé de 5 à 55% en poids d'unités monomères aromatiques bromées sur le cycle, de 20 à 92% en poids d'acrylate d'alkyle, de méthacrylate d'alkyle ou d'unités monomères aromatiques non bromées et de 3 à 25% en poids d'unités monomères acide carboxylique éthyléniquement insaturées, sur base du poids total du copolymère.

4. Composition de résine flexible, ignifuge, exposable selon une image suivant la revendication 3, dans laquelle le monomère aromatique bromé sur le cycle comprend du styrène, du méthylstyrène, de l'alpha-méthylstyrène, de l'alphaméthylméthylstyrène, de l'éthylstyrène ou de l'alphaméthyléthylstyrène mono, di, tri ou tétra substitué par du brome.

5. Composition de résine flexible, ignifuge, exposable selon une image suivant la revendication 1, dans laquelle le liant copolymère carboxylique non bromé (b) comprend le produit réactionnel polymérisé d'un acide carboxylique éthyléniquement insaturé et d'un comonomère de styrène ou d'esters ou d'amides d'acide acrylique et méthacrylique.

6. Composition de résine flexible, ignifuge, exposable selon une image suivant la revendication 1, dans laquelle le composant monomère uréthane acrylé (c) est un uréthanediacrylate comprenant le produit réactionnel du 2,6-toluènediisocyanate avec un polyol avec les groupements de terminaison isocyanate bloqués aux extrémités avec de l'hydroxyéthylacrylate.

7. Composition de résine flexible, ignifuge, exposable selon une image suivant la revendication 1, dans laquelle le composant monomère uréthane acrylé (c) est un uréthanediacrylate bromé comprenant le produit réactionnel du dibromonéopentylglycol avec de l'hexaméthylènediisocyanate et bloqué aux extrémités avec de l'hydroxyéthylacrylate.

8. Composition de résine flexible, ignifuge, exposable selon une image suivant la revendication 1, dans laquelle le composant monomère uréthane acrylé (c) est un uréthanediacrylate bromé comprenant le produit réactionnel du bis(2-hydroxyéthyléther) de tétrabromobisphénol-A avec de l'hexaméthylène-diisocyanate et bloqué aux extrémités avec de l'hydroxyéthylacrylate.

9. Composition de résine flexible, ignifuge, exposable selon une image suivant la revendication 1, dans laquelle le composant monomère uréthane acrylé (c) est un uréthanediacrylate bromé comprenant le produit réactionnel du dibromonéopentylglycol et de polyols avec des diisocyanates aliphatiques ou aromatiques et bloqué aux extrémités avec de l'hydroxyéthylacrylate.
